(19) Europäisches Patentamt / European Patent Office / Office européen des brevets

(11) **EP 2 095 512 B1**

(12) **FASCICULE DE BREVET EUROPEEN**

(45) Date de publication et mention
de la délivrance du brevet:
**18.04.2012 Bulletin 2012/16**

(21) Numéro de dépôt: **07870358.4**

(22) Date de dépôt: **29.11.2007**

(51) Int Cl.:
**H03M 13/11** $^{(2006.01)}$    **H03M 13/39** $^{(2006.01)}$

(86) Numéro de dépôt international:
**PCT/FR2007/001963**

(87) Numéro de publication internationale:
**WO 2008/071884 (19.06.2008 Gazette 2008/25)**

(54) **PROCÉDÉ ET DISPOSITIF DE DÉCODAGE POUR CODES LDPC, ET APPAREIL DE COMMUNICATION COMPRENANT UN TEL DISPOSITIF**

VERFAHREN UND VORRICHTUNG ZUR DEKODIERUNG VON LDPC-CODES UND KOMMUNIKATIONSVORRICHTUNG MIT EINER SOLCHEN VORRICHTUNG

METHOD AND DEVICE FOR DECODING LDPC CODES AND COMMUNICATION APPARATUS INCLUDING SUCH DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **01.12.2006 FR 0655275**

(43) Date de publication de la demande:
**02.09.2009 Bulletin 2009/36**

(73) Titulaire: **Commissariat à l'Énergie Atomique et aux Énergies Alternatives**
**75015 Paris (FR)**

(72) Inventeur: **SAVIN, Valentin**
**38000 Grenoble (FR)**

(74) Mandataire: **Santarelli**
**14 Avenue de la Grande Armée**
**B.P. 237**
**75822 Paris Cedex 17 (FR)**

(56) Documents cités:
**US-A1- 2005 138 516**

• WYMEERSCH H ET AL.: "Log-domain decoding of LDPC codes over GF(q)" PROC., IEEE INTERNATIONAL CONFERENCE ON COMMUNICATIONS, PARIS, FRANCE, 20 juin 2004 (2004-06-20), - 24 juin 2004 (2004-06-24) pages 772-776, XP010710426 ISBN: 0-7803-8533-0
• DECLERCQ D. ET AL: "Extended minsum algorithm for decoding LDPC codes over GF(q)" PROC., IEEE INTERNATIONAL SYMPOSIUM ON INFORMATION THEORY, ADELAIDE, AUSTRALIA, 4 septembre 2005 (2005-09-04), - 9 septembre 2005 (2005-09-09) pages 464-468, XP010846296 ISBN: 0-7803-9151-9
• HONGXIN SONG ET AL.: "Reduced-complexity decoding of Q-ary LDPC codes for magnetic recording" IEEE TRANSACTIONS ON MAGNETICS, vol. 39, no. 2, mars 2003 (2003-03), pages 1081-1087, XP011075938 ISSN: 0018-9464
• VOICILA A. ET AL.: "Algorithmes simplifiés pur le décodage de codes LDPC non-binaires" PROC., 20IÈME COLLOQUE GRETSI, LOUVAIN-LA-NEUVE, BELGE, 6 septembre 2005 (2005-09-06), pages 1-4, XP002434444
• HUANG X ET AL.: "Fast min-sum algorithms for decoding of LDPC over GF(q)" 15 septembre 2006 (2006-09-15), pages 1-4, XP002435726 Extrait de l'Internet: URL:http://arxiv.org/PS_cache/cs/pdf/0609/ 0609089v1.pdf> [extrait le 2007-05-31]

EP 2 095 512 B1

## Description

La présente invention concerne un procédé et un dispositif de décodage, ainsi qu'un appareil de communication comprenant un tel dispositif.

On utilise le codage de mots d'information (d'une longueur généralement notée K) en mots de code (d'une longueur généralement notée N, avec N > K) lorsque l'on souhaite ajouter de la redondance aux informations concernées afin de retrouver l'intégralité des informations d'origine même si une partie de celles-ci est erronée ou perdue, comme dans le cas de la transmission des informations dans un canal perturbé ou de leur stockage sur un support sujet à dégradations (telles des éraflures sur un disque optique).

Le décodage opéré à la réception (ou à la lecture dans le cas du stockage) afin de retrouver les mots d'information d'origine comprend en général une première phase de correction d'erreurs, qui consiste à retrouver précisément le mot de code émis (ou stocké) à partir du mot reçu (vocabulaire également usité pour désigner le mot lu dans le cas du stockage), malgré d'éventuelles erreurs et grâce à la redondance introduite, puis une phase de *"demapping"* qui consiste à réaliser l'opération inverse de celle effectuée lors du codage.

Dans ce cadre, on connaît les codes à matrice de contrôle de parité à faible densité, dénommés dans la suite codes LDPC (selon l'abréviation de la dénomination anglo-saxonne *"Low Density Parity Check"*), tels que décrits par exemple dans l'article *"*Low density parity check codes", de R. Gallager in IEEE Trans. Inform. Theory, vol. IT-8, pp. 21-28, 1962.

Ces codes sont particulièrement intéressants non seulement parce qu'ils sont très proches de la capacité du canal (limite de Shannon) et qu'ils offrent le meilleur compromis possible entre rendement et performance (proches de la limite de Gilbert - Varshamov), mais aussi parce qu'ils admettent un décodage itératif de type passage de message.

Deux principaux algorithmes de décodage des codes LDPC ont été proposés jusqu'ici, qu'il s'agisse de codes binaires (pour lesquels les symboles représentant les informations sont 0 ou 1, c'est-à-dire pris dans le corps de Galois $GF(2)$) ou de codes non binaires (pour lesquels les symboles sont pris dans le corps de Galois $GF(q)$ avec $q>2$).

Le premier, proposé dans l'article précité sous le nom de *"probabilistic decoding"* est généralement connu (et dénommé dans la suite) en tant que décodage SPA (pour *"Sum - Product Algorithm"*) ou BP (pour *"Belief Propagation"*). Cet algorithme est généralement qualifié d'*optimal* puisque le décodage SPA converge vers le maximum de vraisemblance à condition que le graphe bipartite associé au code LDPC ne contienne pas de cycles. Dans le cas des codes LDPC non binaires, cet algorithme est toutefois inutilisable dans un système réel de communications à cause de sa dynamique très importante, ce qui entraine une forte instabilité des calculs effectués. En outre, il nécessite la réalisation d'un nombre important de produits, ce qui le rend complexe, et il est dépendant de la connaissance du bruit thermique.

Le deuxième algorithme de décodage, sous-optimal, est principalement connu sous le nom de MSA (pour *"Min - Sum Algorithm"*). Il est moins complexe que le SPA et indépendant de la connaissance du bruit thermique, mais il présente, en termes de taux d'erreur binaire, une perte de performances par rapport au SPA qui varie généralement de 0.25 dB à 1 dB pour un canal AWGN (de l'anglais *"Additive White Gaussian Noise"* pour bruit blanc gaussien additif), en fonction du rendement, de l'irrégularité ou de la longueur du code utilisé.

Dans ce contexte, l'invention vise ainsi notamment à proposer une solution pour le décodage des codes LDPC, en particulier non binaires, qui allie de bonnes performances (par exemple par rapport au MSA) et une complexité réduite par rapport à l'algorithme optimal (algorithme SPA).

L'invention propose ainsi un procédé de décodage itératif d'un mot reçu, représenté par des valeurs d'un signal, selon un code à matrice de contrôle de parité, du type à passage de messages entre des noeuds de variable et des noeuds de contrôle d'un graphe bipartite associé à ladite matrice, caractérisé en ce qu'il comprend une étape d'initialisation d'au moins un message d'un noeud de variable, en fonction desdites valeurs, par une information représentative du rapport entre la probabilité d'avoir le symbole le plus probable à la position correspondant au noeud de variable et la probabilité d'avoir le symbole courant à ladite position.

Par ailleurs, on peut prévoir selon ce procédé ce qu'il comprend l'une au moins des étapes suivantes:

- détermination d'au moins un message, relatif à un symbole déterminé, d'un noeud de contrôle vers un noeud de variable déterminé, comme la valeur minimale prise, parmi les séquences de symboles vérifiant l'équation au noeud de contrôle en utilisant ledit symbole déterminé au noeud de variable déterminé, par la valeur maximale des messages reçus au noeud de contrôle depuis des noeuds de variable autres que le noeud de variable déterminé et relatifs chacun au symbole associé à cet autre noeud de variable dans la séquence vérifiant l'équation ;
- détermination des messages d'un noeud de variable vers un noeud de contrôle relatifs à l'ensemble des symboles de telle sorte que la valeur minimale desdits messages soit nulle.

La solution ainsi proposée (dénommée dans la suite MMA pour *"Min-Max Algorithm"*) permet d'obtenir de bonnes performances pour une complexité réduite, comme cela ressortira d'exemples de réalisation présentés ci-après.

En pratique, l'étape d'initialisation du message d'un noeud de variable comprend par exemple les étapes suivantes :

- pour chaque symbole de l'alphabet, détermination de la somme des rapports de vraisemblance logarithmique binaires relatifs aux bits non-nuls du symbole et à la position correspondant au noeud de variable et;
- détermination du minimum des sommes déterminées ;
- soustraction à chaque somme déterminée du minimum déterminé.

Par ailleurs, on peut prévoir selon ce procédé une étape de détermination d'une information *a posteriori* relative à un noeud de variable et à un symbole, comme la somme du message initial relatif au symbole audit noeud de variable et de l'ensemble des messages reçus au noeud de variable et relatifs au symbole, auquel cas la fin du procédé itératif peut être déterminée comme suit :

- pour chaque noeud de variable, détermination du symbole pour lequel l'information *a posteriori* est minimale ;
- si la séquence des symboles ainsi déterminés pour l'ensemble des noeuds de variable est un mot de code, utilisation dudit mot de code comme mot estimé.

Selon un mode de réalisation de l'étape de détermination des messages d'un noeud de variable vers un noeud de contrôle donné envisagée plus haut, celle-ci comprend les étapes suivantes :

- pour chaque symbole, détermination de la somme du message initial relatif au symbole audit noeud de variable et de l'ensemble des messages reçus au noeud de variable en provenance d'un noeud de contrôle autre que le noeud de contrôle donné et relatifs au symbole ;
- détermination du minimum parmi les sommes déterminées ;
- pour chaque symbole, soustraction du minimum déterminé à la somme déterminée relative au symbole.

Pour la réalisation pratique de l'étape de détermination d'au moins un message d'un noeud de contrôle vers un noeud de variable déterminé, celle-ci peut comprendre par exemple les étapes suivantes :

- détermination, pour chaque symbole, d'une valeur intermédiaire égale à la valeur minimale prise par la valeur maximale de messages reçus au noeud de contrôle depuis une partie seulement des noeuds de variable associés au noeud de contrôle ;
- détermination de la valeur minimale prise par la valeur maximale parmi des valeurs intermédiaires et des messages reçus d'un noeud de variable associé au noeud de contrôle et n'appartenant pas à ladite partie.

Plus précisément, ces deux étapes peuvent s'écrire comme suit :

- détermination, pour chaque symbole, d'une valeur intermédiaire égale à la valeur minimale prise, parmi les séquences de symboles associés à une partie seulement des noeuds de variable connectés audit noeud de contrôle et tels que la somme des symboles de la séquence multipliés par les coefficients correspondant dans la matrice audit noeuds de variable soit égale audit symbole déterminé, par la valeur maximale des messages reçus au noeud de contrôle depuis les noeuds de variable de ladite partie et relatifs chacun au symbole associé à ce noeud de variable dans ladite séquence ;
- détermination de manière récursive, pour chaque symbole, d'une *nouvelle* valeur intermédiaire égale à la valeur minimale prise, parmi les couples de symboles dont le premier symbole est associé à une valeur intermédiaire *précédemment* calculée et correspondant à une partie des noeuds de variable et le deuxième symbole est associé à un *nouveau* noeud de variable n'appartenant pas à ladite partie, et tels que la somme du premier symbole et du deuxième symbole multiplié par le coefficient dans la matrice du noeud de variable correspondant soit égale audit symbole déterminé, par la valeur maximale entre la valeur intermédiaire précédemment calculée relative au premier symbole dudit couple et le message reçu au noeud de contrôle depuis le nouveau noeud de variable et relatif au deuxième symbole dudit couple. La nouvelle valeur intermédiaire, calculée de cette manière, correspond à une *nouvelle partie* de noeuds de variable comprenant

*l'ancienne partie et le nouveau noeud de variable.*

Il s'agit d'un mode de réalisation particulièrement pratique, dénommé dans la suite « forward - backward » (de l'anglais signifiant *"vers l'avant, vers l'amère"*), qui permet de limiter (de préférence à deux) le nombre de noeuds de variables (c'est-à-dire de dimensions) sur lesquelles on doit rechercher le minimum du maximum.

Par ailleurs, selon un mode de réalisation proposé dans la suite (*"implémentation sélective"*), le procédé comprend une étape de détermination du minimum, parmi des couples de deux symboles appartenant à l'alphabet du code, du maximum de deux valeurs associées respectivement aux deux symboles de chaque couple, comprenant les sous-étapes suivantes :

- détermination d'ensembles regroupant chacun les symboles auxquels sont associées des valeurs comprises dans un intervalle déterminé ;
- sélection d'ensembles, parmi les ensembles déterminés, de telle sorte que la réunion des ensembles sélectionnés contienne au moins un nombre prédéterminé de symboles (ce nombre prédéterminé suffisant au calcul du minimum des maxima visé ici et expliqué plus loin sous le nom de *"formule min-max"*) ;
- utilisation, comme maximum parmi deux valeurs, de la valeur associée au symbole compris dans l'ensemble correspondant à l'intervalle supérieur lorsque les valeurs sont associées à des symboles compris dans des ensembles sélectionnés correspondant à des intervalles distincts ;
- détermination par comparaison du maximum parmi deux valeurs lorsque les valeurs sont associées à des symboles compris dans des ensembles sélectionnés correspondant à un même intervalle.

Le regroupement des symboles par ensembles selon la valeur prise, en pratique par l'utilisation de la partie entière de cette valeur, permet de réduire nettement le nombre de symboles impliqués et de simplifier les opérations de comparaison des valeurs associées aux symboles impliqués.

Le code est par exemple un code à alphabet non-binaire, auquel cas le procédé proposé est particulièrement intéressant.

L'invention propose également un dispositif de décodage itératif d'un mot reçu, représenté par des valeurs d'un signal, selon un code à matrice de contrôle de parité, du type à passage de messages entre des noeuds de variable et des noeuds de contrôle d'un graphe bipartite associé à ladite matrice, caractérisé en ce qu'il comprend :

- des moyens d'initialisation d'au moins un message d'un noeud de variable, en fonction desdites valeurs, par une information représentative du rapport entre la probabilité d'avoir le symbole le plus probable à la position correspondant au noeud de variable et la probabilité d'avoir le symbole courant à ladite position.

Ce dispositif peut comporter des caractéristiques optionnelles correspondant à celles envisagées plus haut pour le procédé de décodage et les avantages associés.

L'invention propose enfin un appareil de communication comprenant un tel dispositif.

D'autres caractéristiques et avantages de l'invention apparaîtront à la lumière de la description qui suit, faite en référence aux dessins annexés dans lesquels :

- la figure 1 donne à titre illustratif un exemple de matrice de parité et de graphe associé ;
- la figure 2 représente les éléments principaux d'un système de communication comprenant un récepteur conforme aux enseignements de l'invention ;
- la figure 3 représente schématiquement la technique de passage de messages entre les noeuds de variable et les noeuds de contrôle ;
- la figure 4 illustre la méthode « forward - backward » utilisée dans le premier mode de réalisation ;
- la figure 5 donne à titre explicatif une illustration des techniques proposées dans le second mode de réalisation ;
- la figure 6 représente une comparaison des performances obtenues en utilisant le décodeur MSA et celui proposé par l'invention pour des codes LDPC binaires et non binaires ;
- la figure 7 représente une comparaison des performances obtenues en utilisant les deux modes de réalisation présentés ci-après ;
- la figure 8 représente une comparaison des complexités du décodage MSA et du décodage proposé par l'invention pour des codes binaires et non binaires.

Deux exemples de réalisation de l'invention sont présentés dans la suite, avec les notations communes suivantes :

- $p$ , un entier strictement positif appelé, *dimension (ou degré d'extension) du corps de Galois ;*
- $q = 2^p$, appelé *cardinal du corps de Galois ;*
- $P(X)$ un polynôme irréductible de degré $p$ à coefficients dans $GF(2) = \{0,1\}$ ;
- $GF(q) = \{0,1,..., q\text{-}1\}$, le *corps de Galois à q éléments,* les éléments de $GF(q)$ étant appelés des *symboles.*

On note que le corps de Galois $GF(q)$ est classiquement défini comme le quotient de l'anneau de polynômes $GF(2)[X]$ par l'idéal engendré par le polynôme $P(X)$, mais que l'on identifie ici, pour la simplicité de l'exposé, le corps de Galois $GF(q)$ à l'ensemble des entiers $\{0,1,..., q\text{-}1\}$ muni des opérations « somme » et « produit » rappelées ci-dessous (en dénommant toutefois chaque élément du corps de Galois *symbole* afin de le distinguer d'un « simple » entier). On rappelle ici que, afin de définir les opérations « somme » et « produit » munissant $GF(q)$ d'une structure de corps, on identifie chaque symbole $a \in GF(q)$ à une séquence binaire $a_0 a_1 ... a_{p-1}$ correspondant à l'écriture de $a$ en base 2, autrement dit $a = \sum_{i=0}^{p-1} a_i 2^i, a_i \in \{0,1\}$. En outre, on associe au symbole $a$ le polynôme $a(X) = \sum_{i=0}^{p-1} a_i X^i$,

avec par conséquent $a(2) = \sum_{i=0}^{p-1} a_i 2^i = a$.

Les valeurs binaires $a_0 a_1 ... a_{p-1}$ seront dénommées dans la suite *les bits du symbole $a \in GF(q)$.*

*La somme de deux* symboles $a, b \in GF(q)$, notée $a \oplus b$, peut alors être définie par la somme bit à bit des symboles $a$ et $b$, autrement dit $(a \oplus b)_i = a_i + b_i$ mod 2.

*Le produit de deux* symboles $a, b \in GF(q)$, noté $a \otimes b$, est quant à lui défini par le produit des polynômes $a(X)$ et $b(X)$ modulo $P(X)$, autrement dit $(a \otimes b)(X) = a(X) \cdot b(X)$ mod $P(X)$.

Un code LDPC sur $GF(q)$ est un code linéaire défini par une *matrice de parité* $H \in \mathbf{M}_{M,N}(GF(q))$ à faible densité d'éléments non nuls (où $\mathbf{M}_{M,N}(GF(q))$ est l'ensemble des matrices à M lignes et N colonnes à coefficients dans $GF(q)$). On peut alors introduire les notions suivantes :

-   $N$, la *longueur de code,* correspond au nombre de colonnes de la matrice $H$ ;
-   $M$, le *nombre de contrôles de parité,* correspond au nombre de lignes de la matrice $H$ ;
-   $K = N - M$, la *dimension du code,* correspond à la longueur du mot d'information ;
-   $x = (x_1, x_2, ......, x_N)$ un *mot de code q -aire, i.e.* une séquence de symboles $x_n \in GF(q)$, tels que $H \cdot x^t = 0$, où $x^t$ est le vecteur transposé de $x$, c'est-à-dire tels que $\bigoplus_{n=1,...,N} h_{m,n} \otimes x_n = 0, \forall m = 1,...,M$, où $h_{m,n}$ est l'élément en ligne m et colonne n de la matrice $H$ ;
-   $(x_{1,0}, x_{1,1}, ....x_{1,p}-1, x_{2,0}, x_{2,1},...x_{2,p-1},......, x_{N,0}, x_{N,1},...x_{N,p-1})$, où $x_{n,0}, x_{n,1}...x_{n,p-1}$ sont les bits du symbole $x_n \in GF(q)$, le *mot de code binaire* correspondant ;
-   $G \in \mathbf{M}_{K,N}(GF(q))$, la *matrice génératrice* du code, *i.e.* une matrice de rang $K$ telle que $H \cdot G^t = 0$, où $G^t$ est la matrice transposée de $G$ ; une séquence $(a_1, a_2, ..., a_K) \in GF(q)^K$ est appelée *mot d'information q -aire* et étant codé en $(x_1, x_2, ....x_N) = (a_1, a_2, ..., a_K) \cdot G$.

On définit comme graphe bipartite, ou graphe de Tanner, associé à un code LDPC un graphe contenant $N + M$ noeuds divisés en deux types :

-   *N noeuds de type variable,* correspondant aux colonnes de la matrice $H$ ;
-   *M noeuds de type contrôle,* correspondant aux lignes de la matrice $H$ ;

et dans lequel un noeud de variable est connecté à un noeud de contrôle si et seulement si l'élément correspondant de la matrice $H$ définissant le code est non nul.

On utilise dans la suite les notations suivantes :

-   les indices $m, n$ désignent un noeud de contrôle, respectivement un noeud de variable ;
-   $H(m)$ désigne l'ensemble des noeuds de variable connectés au noeud de contrôle $m$, son cardinal étant appelé *degré du noeud de contrôle m* ;
-   $H(n)$ désigne l'ensemble des noeuds de contrôle connectés au noeud de variable $n$, son cardinal étant appelé *degré du noeud de variable n.*

Pour plus de détails sur ce type de graphes, on peut se référer à l'article ″A recursive approach to low complexity codes″ de R. M. Tanner in IEEE Trans. Inform. Theory, vol. 27, no. 5, pp. 533 - 547, 1981.

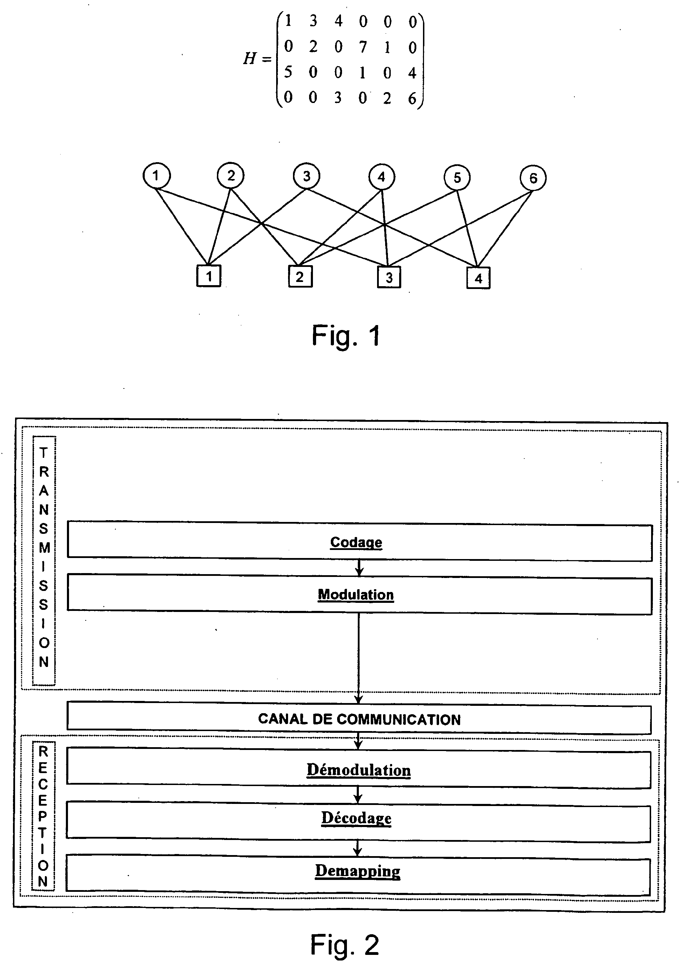

À titre illustratif, la figure 1 représente un exemple de matrice de parité d'un code LDPC sur $GF(8)$ et le graphe bipartite associé. À chaque arête du graphe bipartite correspond un coefficient non nul de $H$ mais, pour ne pas surcharger la représentation graphique, on a omis de reporter les coefficients de $H$ sur les arêtes du graphe.

La figure 2 décrit le schéma d'un système de communication utilisant un code LDPC non binaire et comprenant un appareil de réception conforme aux enseignements de l'invention.

À l'émission (c'est-à-dire au niveau d'un appareil d'émission des informations à transmettre), en particulier au sein d'un module de codage, un *mot d'information binaire* $(a_{1,0}, a_{1,1}, ... a_{1,p-1}, ......, a_{K,0}, a_{K,1}, ... a_{K,p-1})$ est transformé en un *mot d'information q -aire* ($a_1,...,a_K$), où $a_k$ est le symbole déterminé par les bits $a_{k,0}a_{k,1} ... a_{k,p-1}$, puis le mot d'information q -aire est codé en le *mot de code q -aire* ($x_1, x_2,..., x_N$) ($a_1,..., a_K$)·G. Le mot de code q -aire ($x_1,x_2,...,x_N$) est alors transformé en un *mot de code binaire* ($x_{1,0},x_{1,1},...,x_{1,p-1}, x_{2,0}, x_{2,1},...x_{2,p-1},......,x_{N,0}, x_{N,1},...x_{N,p-1}$).

En pratique, on peut naturellement passer directement du mot d'information binaire au mot de code binaire en utilisant une matrice génératrice binaire.

Le mot de code binaire généré par le module de codage est transmis au module de *modulation,* qui le transforme en un signal à émettre dans le *canal de communication.*

L'appareil de réception comprend :

- un module de *démodulation,* qui détermine les rapports de vraisemblance logarithmique binaires (dénommés dans la suite *LLR binaires,* d'après la formulation anglo-saxonne *"Logarithmic Likelihood Ratio"*), notés $\lambda_{n,i}$, $n \in \{1,...,N\}$, $i \in \{0,...,p-1\}$, correspondant au signal reçu dans le canal de communication selon la formule :

$$\lambda_{n,i} = \ln\left(\frac{\Pr(x_{n,i} = 0 \mid \text{observation du canal})}{\Pr(x_{n,i} = 1 \mid \text{observation du canal})}\right) ;$$

- un module de correction d'erreurs (dénommé dans la suite *décodeur),* qui détermine, au moyen du procédé de décodage proposé par l'invention et dont deux exemples sont donnés ci-après, une séquence q -aire de longueur N (égale au mot de code q -aire émis lorsque le décodage réussit) sur la base de la séquence des LLR binaires reçus du module de démodulation ;
- un module de *demapping* qui transforme la séquence q-aire en sortie du décodeur en un mot d'information, qui correspond en cas de réussite du décodage au mot d'information émis ($a_1,...,a_K$).

On décrit à présent un premier exemple d'un procédé de décodage proposé par l'invention, mis en oeuvre au sein du module de correction d'erreurs (ou décodeur) et qui permet l'estimation d'un mot reçu (ou séquence q-aire) sur la base des LLR binaires fournis par le module de démodulation.

Le décodage proposé est réalisé de manière itérative et avec passage de messages. Ce procédé comprend ainsi :

- une étape d'initialisation sur la base des LLR binaires fournis par le module de démodulation ;
- des étapes d'itération pendant lesquelles des messages sont échangés entre les noeuds de variable et les noeuds de contrôle connectés dans le graphe bipartite, la première étape d'itération étant appliquée aux valeurs issues de l'étape d'initialisation, tandis que les étapes suivantes sont appliquées aux valeurs résultant de l'étape précédente.

L'étape d'initialisation commence par un calcul des *informations a priori disponibles aux noeuds de variable n* $\in \{1,... N\}$ *concernant les symboles a* $\in GF(q)$, notées $\gamma_n(a)$, avec selon le procédé de décodage présenté ici :

$$\gamma_n(a) = \ln\left(\frac{\Pr(x_n = s_n \mid \text{observation du canal})}{\Pr(x_n = a \mid \text{observation du canal})}\right)$$

où $s_n$ dénote le symbole le plus probable pour $x_n$, en tenant compte de l'observation du canal.

En remarquant que :

$$\gamma_n(a) = \ln\left(\frac{\Pr(x_n = 0 \mid \text{observation du canal})}{\Pr(x_n = a \mid \text{observation du canal})}\right) - \ln\left(\frac{\Pr(x_n = 0 \mid \text{observation du canal})}{\Pr(x_n = s_n \mid \text{observation du canal})}\right)$$

$$= \ln\left(\frac{\Pr(x_n = 0 \mid \text{observation du canal})}{\Pr(x_n = a \mid \text{observation du canal})}\right) - \min_{s \in GF(q)} \ln\left(\frac{\Pr(x_n = 0 \mid \text{observation du canal})}{\Pr(x_n = s \mid \text{observation du canal})}\right)$$

on peut calculer comme suit les informations *a priori* (ci-dessous, $a_i$ dénote le $i^{\text{ième}}$ bit du symbole *a*), et ce à chaque noeud de variable n et pour tout symbole a de l'alphabet :

$$\gamma_n(a) = \sum_{\substack{i=0,\ldots,p-1 \\ bit\, a_i = 1}} \lambda_{n,i}$$
$$\gamma_n = \min_{a \in GF(q)} \gamma_n(a)$$
$$\gamma_n(a) = \gamma_n(a) - \gamma_n$$

Chaque information *a priori* $\gamma_n(a)$ donne donc une mesure de la fiabilité du symbole a (pour la position n), sous forme d'une distance au symbole le plus probable.

L'étape d'initialisation peut alors se poursuivre (et s'achever) par l'initialisation des *messages des noeuds de variable vers les noeuds de contrôle* (appelés aussi *informations extrinsèques*). On note $\alpha_{m,n}(a)$ le *message envoyé par le noeud de variable n $\in$ {1,...N} au noeud de contrôle m $\in$ H(n) concernant le symbole a $\in$ GF(q).*

Selon le procédé de décodage proposé ici, on initialise les informations extrinsèques à partir des informations *a priori* comme suit :

$$\alpha_{m,n}(a) = \gamma_n(a)$$

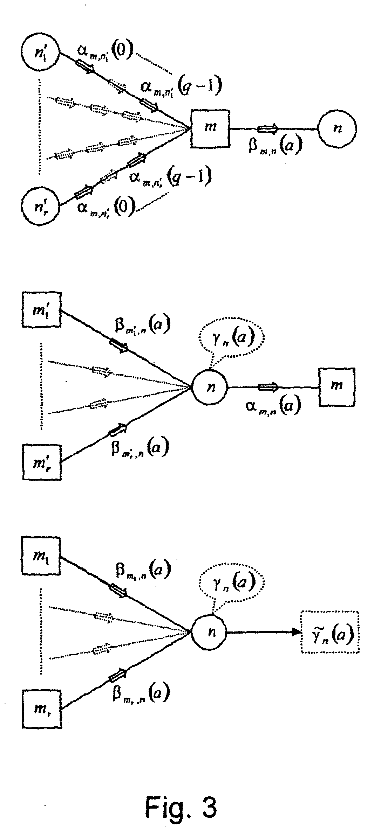

Chaque étape d'itération est réalisée par passage de messages entre les noeuds du graphe bipartite, comme représenté schématiquement en figure 3, et comprend ainsi les sous-étapes suivantes :

- calcul des messages des noeuds de contrôle vers les noeuds de variable. On note $\beta_{m,n}(a)$ le message envoyé par le noeud de contrôle $m \in$ {1,...M} au noeud de variable $n \in H(m)$ concernant le symbole $a \in GF(q)$. Ce message est calculé en fonction des messages $\alpha_{m,n}(a')$ reçus par le noeud de contrôle m des noeuds de variable $n' \in H(m)$ - {n}, concernant tous les symboles $a' \in GF(q)$, avec selon la méthode de décodage proposée ici :

$$\beta_{m,n}(a) = \min_{\substack{a_{n'} \in GF(q):\, n' \in H(m)-\{n\} \\ \left( \underset{n' \in H(m)-\{n\}}{\oplus} h_{m,n'} \otimes a_{n'} \right) \oplus (h_{m,n} \otimes a) = 0}} \quad \max_{n' \in H(m)-\{n\}} \alpha_{m,n'}(a_{n'})$$

- calcul des *informations a posteriori.* On note $\tilde{\gamma}_n(a)$ *l'information* a posteriori calculée au noeud de variable $n \in$ {1,... N} concernant le symbole $a \in GF(q)$. Cette information est calculée en fonction de l'information a priori $\gamma_n(a)$ disponible au noeud de variable *n* et des messages $\beta_{m,n}(a)$ reçus par le noeud de variable n des noeuds de contrôle $m \in H(n)$, concernant le symbole $a \in GF(q)$, ici selon la formule :

$$\tilde{\gamma}_n(a) = \gamma_n(a) + \sum_{m \in H(n)} \beta_{m,n}(a)$$

- calcul des messages des noeuds *de variable vers les noeuds de contrôle* (ou *informations extrinsèques).* Le (nouveau) message $\alpha_{m,n}(a)$ est calculé en fonction de l'information a priori $\gamma_n(a)$ disponible au noeud de variable n et des messages $\beta_{m',n}(a)$ reçus par le noeud de variable *n* des noeuds de contrôle $m' \in H(n)$ - {m}, concernant le symbole $a \in GF(q)$, ici selon :

$$\alpha_{m,n}(a) = \gamma_n(a) + \sum_{m' \in H(n)-\{m\}} \beta_{m',n}(a) = \tilde{\gamma}_n(a) - \beta_{m,n}(a)$$
$$\alpha_{m,n} = \min_{a \in GF(q)} \alpha_{m,n}(a)$$
$$\alpha_{m,n}(a) = \alpha_{m,n}(a) - \alpha_{m,n}$$

Ainsi, pour le symbole le plus probable $s_n$ (c'est-à-dire tel que $\alpha_{m,n} = \alpha_{m,n}(s_n)$), on a toujours à chaque itération $\alpha_{m,n}(s_n) = 0$

À chaque itération, une *décision dure* correspondant aux symboles les plus probables peut être calculée à partir des informations *a posteriori* $\tilde{\gamma}_n(a)$, $n \in \{1, \ldots N\}$, $a \in GF(q)$. Comme déjà relevé, les symboles les plus probables sont ceux qui réalisent le minimum des informations a *posteriori* $\tilde{\gamma}_n(a)$. Si la séquence de ces symboles les plus probables correspond à un mot de code, on considère que le mot de code trouvé est le mot de code émis à l'origine : le décodage s'arrête et on passe le mot de code trouvé au module de *demapping.*

En revanche, si la séquence de ces symboles les plus probables ne correspond pas à un mot de code, le décodage continue jusqu'à ce qu'un nombre maximum prédéterminé d'itérations soit atteint, dans quel cas on considère que le décodage a échoué.

L'intérêt de la formule min - max utilisée dans le calcul des messages des noeuds de contrôle $\beta_{m,n}(a)$ peut s'expliquer comme suit.

Dans la suite on fixe un noeud de contrôle *m*, un noeud de variable *n* connecté au noeud de contrôle *m* et un symbole $a \in GF(q)$. On note $n_1,\ldots,n_d$ les autres noeuds de variable (*i.e.* différents de *n*) connectés au noeud de contrôle *m*. Ainsi, nous avons $H(m) = \{n, n_1,\ldots,n_d\}$ avec les notations précédentes.

Le message $\beta_{m,n}(a)$ est calculé en fonction des messages reçus par le noeud de contrôle *m* des noeuds de variable $n_1,\ldots,n_d$ (*et* ce pour chaque symbole de *GF(q)*).

Si on considère une séquence de symboles $(a_1,\ldots,a_d)$ comprenant un symbole pour chaque noeud de variable $n_1,\ldots,n_d$, on dira dans ce qui suit qu'une telle séquence est admissible si la séquence $(a, a_1\ldots, a_d)$ - comprenant un symbole pour chaque noeud de variable $n, n_1,\ldots,n_d$ - satisfait le contrôle m, c'est-à-dire l'équation de la matrice de parité à la ligne m :

$$\left( \bigoplus_{k=1}^{d} h_{m,n_k} \otimes a_k \right) \oplus \left( h_{m,n} \otimes a \right) = 0$$

Une séquence admissible est donc susceptible de constituer une partie d'un mot de code.

Le calcul de $\beta_{m,n}(a)$ prend en compte la totalité des séquences admissibles. Ainsi, pour chaque séquence admissible $(a_1,\ldots,a_d)$, on peut calculer le maximum des messages reçus par le noeud de contrôle *m* des noeuds de variable $n_1\ldots,n_d$ concernant les symboles de cette séquence qui donne une mesure de la fiabilité de cette séquence (une valeur faible correspondant comme vu *supra* à une information fiable). Précisément, il s'agit de :

$$\max_{k=1,\ldots,d} \left( \alpha_{m,n_k}(a_k) \right).$$

Si on note ce maximum par $M(a_1,\ldots, a_d)$, le message $\beta_{m,n}(a)$ est alors égal au minimum de tous les maximums calculés pour la totalité des séquences admissibles, c'est-à-dire :

$$\beta_{m,n}(a) = \min_{\substack{(a_1,\ldots,a_d) \\ \text{admissible}}} M(a_1,\ldots,a_d)$$

$$= \min_{\substack{(a_1,\ldots,a_d) \\ \text{admissible}}} \left( \max_{k=1,\ldots,d} \left( \alpha_{m,n_k}(a_k) \right) \right).$$

Ce minimum vise donc la plus probable des séquences admissibles et donne une mesure de sa fiabilité.

On obtient ainsi une information sur la fiabilité du symbole a à la position n qui tient compte des autres informations disponibles au noeud de contrôle m.

On propose dans la suite une première méthode pratique pour mettre en oeuvre le calcul des messages $\beta_{m,n}(a)$ sans avoir à lister à chaque fois l'ensemble des séquences admissibles. Ce premier mode de réalisation utilise une méthode de type « forward - backward » et peut être exprimé comme suit.

**Algorithme Min - Max**

*Entrée:* $\lambda_{1,0}$, $\lambda_{1,1},\ldots,\lambda_{1,p-1}$, $\lambda_{2,0}$, $\lambda_{2,1},\ldots, \lambda_{2,p-1},\ldots\ldots, \lambda_{N,0}$, $\lambda_{N,1},\ldots, \lambda_{N,p-1}$ -LLR binaires *Sortie : $s_1,s_2,\ldots\ldots,s_N$* - séquence q -aire

**Initialisation**

• *Informations a priori*

Pour chaque noeud de variable $n \in \{1,2,...,N\}$ faire :

$$\gamma_n(a) = \sum_{\substack{i=0,...,p-1 \\ \text{bit } a_i=1}} \lambda_{n,i}; \qquad \left.\right] \forall a \in GF(q)$$

$$\gamma_n = \min_{a \in GF(q)} \gamma_n(a);$$

$$\gamma_n(a) = \gamma_n(a) - \gamma_n ; \qquad \left.\right] \forall a \in GF(q)$$

• *Initialisation des messages des noeuds de variable*

Pour chaque noeud de variable $n \in \{1,2,...,N\}$ et chaque noeud de contrôle $m \in H(n)$ faire :

$$\alpha_{m,n}(a) = \gamma_n(a); \qquad \left.\right] \forall a \in GF(q)$$

**Itérations**

• *Messages des noeuds de contrôle*

Pour chaque noeud de contrôle $m \in \{1,2,...,M\}$ (on pose $H(m) = \{n_1, n_2,...,n_d\}$, $d$ étant par conséquent le cardinal de $H(m)$) faire :
// forward

$$F_1(a) = \alpha_{m,n_1}\left(h_{m,n_1}^{-1} \otimes a\right); \qquad \forall a \in GF(q)$$

$$F_j(a) = \min_{\substack{a',a'' \\ a' \oplus (h_{m,n_j} \otimes a'')=a}} \left(\max\left(F_{j-1}(a'), \alpha_{m,n_j}(a'')\right)\right); \qquad \forall a \in GF(q), \forall j = 2,...,d-1$$

// backward

$$B_d(a) = \alpha_{m,n_d}\left(h_{m,n_d}^{-1} \otimes a\right); \qquad \forall a \in GF(q)$$

$$B_j(a) = \min_{\substack{a',a'' \\ a' \oplus (h_{m,n_j} \otimes a'')=a}} \left(\max\left(B_{j+1}(a'), \alpha_{m,n_j}(a'')\right)\right); \qquad \forall a \in GF(q), \forall j = d-1,...,2$$

// messages du noeud de contrôle m

$$\beta_{m,n_1}(a) = B_2(a); \qquad\qquad \left.\vphantom{\begin{array}{c}1\\1\\1\end{array}}\right\} \forall a \in GF(q)$$

$$\beta_{m,n_j}(a) = \min_{\substack{a',a''\\a'\oplus a''=h_{m,n_j}\otimes a}} \left(\max\left(F_{j-1}(a'), B_{j+1}(a'')\right)\right); \qquad \forall a \in GF(q), \forall j = 2,\ldots,d-1$$

$$\beta_{m,n_d}(a) = F_{d-1}(a); \qquad\qquad \forall a \in GF(q)$$

• *Informations a posteriori*

Pour chaque noeud de variable $n \in \{1,2,\ldots,N\}$ faire :

$$\widetilde{\gamma}_n(a) = \gamma_n(a) + \sum_{m \in H(n)} \beta_{m,n}(a); \qquad \left.\vphantom{\sum}\right] \forall a \in GF(q)$$

• *Décision dure : choix des symboles les plus probables*

Pour chaque noeud de variable $n \in \{1,2,\ldots, N\}$ faire :

$$s_n = \arg\min_{a \in GF(q)} \widetilde{\gamma}_n(a);$$

$$\text{Si } \bigoplus_{n \in H(m)} \left(h_{m,n} \otimes s_n\right) = 0, \ \forall m \in \{1,2,\ldots,M\} \text{ alors SORTIR ;}$$

• *Messages des noeuds de variable*

Pour chaque noeud de variable $n \in \{1,2,\ldots,N\}$ et chaque noeud de contrôle $m \in H(n)$ faire :

$$\alpha_{m,n}(a) = \widetilde{\gamma}_n(a) - \beta_{m,n}(a); \qquad \left.\vphantom{\begin{array}{c}1\\1\end{array}}\right] \forall a \in GF(q)$$

$$\alpha_{m,n} = \min_{a \in GF(q)} \alpha_{m,n}(a);$$

$$\alpha_{m,n}(a) = \alpha_{m,n}(a) - \alpha_{m,n}; \qquad \left.\vphantom{\begin{array}{c}1\\1\end{array}}\right] \forall a \in GF(q)$$

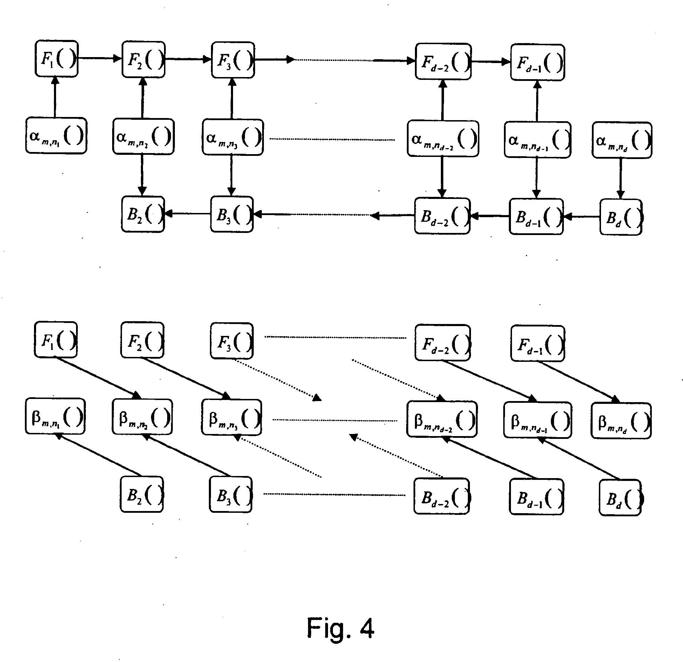

La méthode « forward - backward » utilisée dans ce mode de réalisation est illustrée à la figure 4. La notation $\alpha_{m,n}()$ désigne l'ensemble des messages $\alpha_{m,n}(a)$, $a \in GF(q)$ ; de même pour $F_j(\ )$, $B_j()$ et $\beta_{m,n}(\ )$. L'utilisation de quantités (ou valeurs) intermédiaires $F_j(\ )$, $B_j(\ )$ permet de n'impliquer que des formules à deux symboles ($a'$, $a''$) c'est-à-dire de n'avoir à chaque fois à déterminer le minimum des valeurs maximales que sur deux dimensions.

Par ailleurs, les formules utilisées ci-dessus pour déterminer les $F_j(a)$ et $B_j(a)$ dans le calcul des messages des noeuds de contrôle (formules de type « min - max ») peuvent être mises en oeuvre comme suit.

Pour simplifier l'explication, on néglige ici la valeur des coefficients de la matrice $H$ (*i.e.* on considère que $h_{m,n}$ =1, $\forall n \in H(m)$), ce qui permet d'exprimer une telle formule sous la forme :

$$f(a) = \min_{\substack{a',a'' \in GF(q)\\a'\oplus a''=a}} \left(\max\left(f'(a'), f''(a'')\right)\right).$$

et de procéder à son calcul comme suit :

Pour $a \in GF(q)$ initialiser : $f(a) = +\infty$ ;
Pour $a' \in GF(q)$ faire :

Pour $a'' \in GF(q)$ faire :

$$a = a' \oplus a''\,;$$

$$f = \max\left(f'(a'), f''(a'')\right);$$

$$\text{Si } f < f(a) \text{ alors } f(a) = f\,;$$

On note que la complexité de ce calcul est proportionnelle à $q^2$.

On peut remarquer par ailleurs que, vues les formules utilisées, la dynamique des messages échangés est faible et aucune normalisation n'est pas conséquent nécessaire. De plus, la solution proposée est indépendante de la connaissance du bruit thermique.

On décrit à présent un second mode de réalisation de l'invention dans lequel la faible dynamique évoquée plus haut est utilisée pour réduire la complexité. On vise notamment à réduire le coût des calculs min-max de la forme

$$f(a) = \min_{\substack{a', a'' \in GF(q) \\ a' \oplus a'' = a}} \left(\max\left(f'(a'), f''(a'')\right)\right)$$

On peut constater en pratique (et il est en outre démontré dans l'annexe *infra*) que, pour ce calcul, il suffit de considérer seulement les symboles $a'$ et $a''$ correspondant aux $q + 1$ valeurs les plus faibles parmi les $f'(a')$ et $f''(a'')$ (soit $2.\,q$ valeurs au total).

On note $q'$, $q''$ le nombre de symboles $a'$, respectivement $a''$, correspondant *aux* $q + 1$ valeurs les plus faibles parmi les $f'(a')$ et $f''(a'')$. On a alors $q' + q'' = q + 1$ et la complexité du calcul ci-dessus devient proportionnelle à

$$q' \cdot q'' \in \left\{ q, q + 1, \dots, \frac{q}{2}\left(\frac{q}{2} + 1\right) \right\}.$$

On pourrait alors envisager de réduire la complexité du calcul des $f(a)$, $a \in GF(q)$, à condition de trier les valeurs $f'(a')$ et $f''(a'')$. Or, le tri des valeurs $f'(a')$ et $f''(a'')$ rajouterait une complexité non négligeable aussi bien en termes de nombre d'opérations que d'accès mémoire.

Afin d'éviter le tri des valeurs $f'(a')$ et $f''(a'')$, on stocke ici les symboles $a'$ et $a''$ selon la partie entière de $f'(a')$ et de $f''(a'')$. On note alors les ensembles $\Delta'_k$ (respectivement $\Delta''_k$) contenant les symboles $a'$ tels que $\lfloor f'(a') \rfloor = k$ (respectivement les symboles $a''$ tels que $\lfloor f''(a'') \rfloor = k$) où l'opérateur $\lfloor \; \rfloor$ désigne la partie entière.

$$\Delta'_k = \left\{ a' \in GF(q) \,\big|\, \lfloor f'(a') \rfloor = k \right\}$$

$$\Delta''_k = \left\{ a'' \in GF(q) \,\big|\, \lfloor f''(a'') \rfloor = k \right\}$$

Il suffirait alors de déterminer le plus petit entier $E$ tel que le nombre de symboles $a'$ et $a''$ contenus dans les ensembles $\Delta' = \Delta'_0 \cup \cdots \cup \Delta'_E$ et $\Delta'' = \Delta''_0 \cup \cdots \cup \Delta''_E$ soit supérieur ou égal à $q + 1$ ; ensuite de calculer $f(a)$ en utilisant :

$$f(a) = \min_{\substack{a' \in \Delta', a'' \in \Delta'' \\ a' \oplus a'' = a}} \left(\max\left(f'(a'), f''(a'')\right)\right)$$

Bien sûr, en utilisant cette méthode, on peut avoir à utiliser plus de symboles que le cardinal du corps plus un ( $> q + 1$ ), mais on évite ainsi le tri des valeurs $f'(a')$ et $f''(a'')$.

L'utilisation des ensembles $\Delta'_k$ et $\Delta''_k$ a un double intérêt :

- on diminue le nombre de symboles (donc le nombre de boucles) nécessaires au calcul des formules de type « min - max » ;

- la plupart des calculs de maximum deviennent obsolètes. Ainsi, le maximum $\max(f'(a'), f''(a''))$ doit être calculé seulement si les symboles $a'$ et $a''$ se trouvent dans des ensembles de même rang, *i.e.* $a' \in \Delta'_{k'}$ et $a'' \in \Delta''_{k''}$ avec $k' = k''$. Dans les autres cas, le maximum correspond au symbole de l'ensemble de rang maximal (*i.e.* max = $f'(a')$ si $k' > k''$ et max = $f''(a'')$ si $k'' > k'$).

Pour utiliser cette méthode, on procède comme suit :

- on définit une dynamique prédéfinie des informations *a priori*, de sorte que la partie entière des messages échangés nous fournisse un critère suffisamment fin pour distinguer entre les symboles de l'alphabet (ici le corps de Galois *GF(q)*). Pour cela on utilise une constante *AI* (pour *"Average a priori Information"*) et dans l'étape d'initialisation, après le calcul des informations *a priori* (*cf.* premier mode de réalisation), on calcule :

$$\gamma_{\text{ave}} = \text{moyenne des} \left\{ \gamma_n(a) \,\middle|\, n \in \{1, 2, \ldots N\}, a \in GF(q) \right\};$$

puis on normalise les informations a priori :

$$\gamma_n(a) = \frac{AI}{\gamma_{\text{ave}}} \cdot \gamma_n(a); \text{ pour } n \in \{1, \ldots, N\}, a \in GF(q)$$

- on définit une dynamique maximale des messages des noeuds de contrôle, afin d'avoir un nombre réduit d'ensembles $\Delta'_k$ et $\Delta''_k$. Pour cela on utilise une constante *COT* (pour *"Cut Off Threshold')* et le calcul de la formule « min-max » se fait comme décrit ci-dessous :

// déterminer les ensembles $\Delta'_k$ et $\Delta''_k$

pour $a \in GF(q)$ faire

si $(k = \lfloor f'(a') \rfloor) < COT$ alors rajouter a à $\Delta'_k$

si $(k = \lfloor f''(a'') \rfloor) < COT$ alors rajouter a à $\Delta''_k$

// déterminer le nombre d'ensemble à utiliser (noté *E*)
$card$ = 0;
pour $(E = 0 ; E < COT\text{-}1 ; E{+}{+})$

si $\left( card + = \left( card\left(\Delta'_E\right) + card\left(\Delta''_E\right) \right) \right) \geq q + 1$ alors sortir de la boucle

On définit ainsi *E* de telle manière que les ensembles $\Delta' = \Delta'_0 \cup \cdots \cup \Delta'_E$ et $\Delta'' = \Delta''_0 \cup \cdots \cup \Delta''_E$ regroupent au moins $q + 1$ éléments (comme vu *supra*), sauf dans les cas où la valeur maximale pour *E* (c'est-à-dire la valeur *COT* -1) est atteinte.

A la sortie de la boucle, *E* définit ainsi le nombre d'ensembles qui seront utilisés. On note qu'il est possible que la boucle aille à son terme, dans quel cas $E = COT$ -1 (valeur maximale de *E* atteinte) et $card(\Delta'' \cup \cdots \cup \Delta'')$ peut alors être inférieur à $q + 1$ (donc le nombre de symboles $a'$ et $a''$ qui seront utilisés est inférieur à $q + 1$ et, par conséquent, la complexité du calcul « min-max » sera encore plus réduite). Cela se produit généralement pendant les dernières itérations, lorsque le décodage est bien avancé et que le décodeur ne met plus en doute qu'un nombre très faible de symboles.

Lorsque cela sera nécessaire, pour mettre en évidence le fait que l'entier $E$ est déterminé à partir des ensembles $\Delta'_k$ et $\Delta'_k$, $0 \leq k < COT$, on notera $E = E(\Delta', \Delta'')$.

On propose donc l'algorithme suivant :

// calcul de la formule « min-max » implémentation sélective
pour $a \in GF(q)$ initialiser : $f(a) = COT$;

pour $k' = 0,..., E$ et $a' \in \Delta'_{k'}$ faire :

    pour $k'' = 0,...,k'-1$ et $a'' \in \Delta''_{k''}$ faire:

$$a = a' \oplus a'';$$

    // notons que $f'(a') = \max(f'(a'), f''(a''))$ car $k' > k''$
    si $f'(a') < f(a)$ alors $f(a) = f'(a')$

pour $k'' = 0,..., E$ et $a'' \in \Delta''_{k''}$ faire :

    pour $k' = 0, ... , k''-1$ et $a' \in \Delta'_{k'}$ faire :

$$a = a' \oplus a'';$$

    1/ notons que $f''(a'') = \max(f'(a'), f''(a''))$ car $k'' > k'$
    si $f''(a'') < f(a)$ alors $f(a) = f''(a'')$

pour $k = 0,...,E$ faire :

    pour $a' \in \Delta'_k$ et $a'' \in \Delta''_k$ faire :

$$a = a' \oplus a'';$$

$$f = \max\left(f'\left(a'\right), f''\left(a''\right)\right)$$

$$\text{si } f < f(a) \text{ alors } f(a) = f$$

Nous allons maintenant donner la description complète du deuxième mode de réalisation de l'algorithme proposé par la présente invention.

On définit trois types d'ensembles :

- ensembles $A_j\Delta_k$ : contiennent les symboles $a \in GF(q)$ tels que $\lfloor a_{m,n_j}(a) \rfloor = k$,
- ensembles $F_j\Delta'_k$ : contiennent les symboles $a \in GF(q)$ tels que $\lfloor F_j(a) \rfloor = k$,
- ensembles $B_j\Delta'_k$ : contiennent les symboles $a \in GF(q)$ tels que $\lfloor B_j(a) \rfloor = k$.

Les notations du premier mode de réalisation sont conservées dans cette description.

L'algorithme proposé dans ce second mode de réalisation est alors le suivant :

### Algorithme Min - Max

*Entrée :* $\lambda_{1,0}, \lambda_{1,1},..., \lambda_{1,p-1}, \lambda_{2,0}, \lambda_{2,1},..., \lambda_{2,p-1},..........,\lambda_{N,0},\lambda_{N,1},...,\lambda_{N,p-1}$-LLR binaires
*Sortie :* $S_1, S_2,..........,S_N$ -séquence q -aire

définir *AI* ar exemple : *AI* = 4.647 pour *GF*(8)
définir *COT* , par exemple : *COT* =10 pour *GF*(8)

## Initialisation

• *Informations a priori*

Pour chaque noeud de variable $n \in \{1,2,...,N\}$ faire :

$$\gamma_n(a) = \sum_{\substack{i=0,...,p-1 \\ \text{bit } a_i=1}} \lambda_{n,i}; \qquad \forall a \in GF(q)$$

$$\gamma_n = \min_{a \in GF(q)} \gamma_n(a);$$

$$\gamma_n(a) = \gamma_n(a) - \gamma_n; \qquad \forall a \in GF(q)$$

Faire : $\gamma_{ave}$ = moyenne des $\{\gamma_n(a)|n \in \{1,2,... N\}, a \in GF(q)\}$;
Pour chaque noeud de variable $n \in \{1,2,...,N\}$ faire :

$$\gamma_n(a) = \frac{AI}{\gamma_{ave}} \cdot \gamma_n(a); \qquad \forall a \in GF(q)$$

• *Initialisation des messages des noeuds de variable*

Pour chaque noeud de variable $n \in \{1,2,...,N\}$ et chaque noeud de contrôle $m \in H(n)$ faire :

$$\alpha_{m,n}(a) = \gamma_n(a); \qquad \forall a \in GF(q)$$

## Itérations

• *Messages des noeuds de contrôle*

Pour chaque noeud de contrôle $m \in \{1,2,..., M\}$ (on pose $H(m) = \{n_1,n_2,...,n_d\}$) faire :

// ensembles $A_j\Delta_k$;

$$\text{Déterminer les ensembles } A_j\Delta_k ; \qquad \forall a \in GF(q), \forall j = 1,...,d$$

// forward

$$F_1(a) = \alpha_{m,n_1}\left(h_{m,n_1}^{-1} \otimes a\right);$$

**Déterminer les ensembles** $F_1\Delta_k$ ;

$$E = E\left(F_{j-1}\Delta, A_j\Delta\right);$$

$$F_j(a) = \min_{\substack{a' \in \bigcup_{k=0}^{E} F_{j-1}\Delta_{k'}, a'' \in \bigcup_{k=0}^{E} A_j\Delta_{k'} \\ a' \oplus (h_{m,n_j} \otimes a'') = a}} \left(\max\left(F_{j-1}(a'), \alpha_{m,n_j}(a'')\right)\right);$$

**Déterminer les ensembles** $F_j\Delta_k$ ;

$$\forall a \in GF(q)$$

$$\forall a \in GF(q)$$

$$\forall j = 2,\ldots,d-1$$

// backward

$$B_d(a) = \alpha_{m,n_d}\left(h_{m,n_d}^{-1} \otimes a\right);$$

**Déterminer les ensembles** $B_d\Delta_k$ ;

$$E = E\left(B_{j+1}\Delta, A_j\Delta\right);$$

$$B_j(a) = \min_{\substack{a' \in \bigcup_{k=0}^{E} B_{j+1}\Delta_{k'}, a'' \in \bigcup_{k=0}^{E} A_j\Delta_{k'} \\ a' \oplus (h_{m,n_j} \otimes a'') = a}} \left(\max\left(B_{j+1}(a'), \alpha_{m,n_j}(a'')\right)\right);$$

**Déterminer les ensembles** $B_j\Delta_k$ ;

$$\forall a \in GF(q)$$

$$\forall a \in GF(q)$$

$$\forall j = d-1,\ldots,2$$

// messages du noeud de contrôle $m$

$$\beta_{m,n_1}(a) = B_2(a);$$

$$E = E\left(F_{j-1}\Delta, B_{j+1}\Delta\right);$$

$$\beta_{m,n_j}(a) = \min_{\substack{a' \in \bigcup_{k=0}^{E} F_{j-1}\Delta_{k'}, a'' \in \bigcup_{k=0}^{E} B_{j+1}\Delta_{k'} \\ a' \oplus a'' = h_{m,n_j} \otimes a}} \left(\max\left(F_{j-1}(a'), B_{j+1}(a'')\right)\right);$$

$$\forall a \in GF(q)$$

$$\forall a \in GF(q)$$

$$\forall j = 2,\ldots,d-1$$

$$\beta_{m,n_d}(a) = F_{d-1}(a);$$

$$\forall a \in GF(q)$$

- *Informations a posteriori*

Pour chaque noeud de variable $n \in \{1,2,\ldots,N\}$ faire :

$$\tilde{\gamma}_n(a) = \gamma_n(a) + \sum_{m \in H(n)} \beta_{m,n}(a);$$

$$\forall a \in GF(q)$$

• *Décision dure : choix des symboles les plus probables*

Pour chaque noeud de variable $n \in \{1,2,..., N\}$ faire :

$$s_n = \operatorname*{arg\,min}_{a \in GF(q)} \widetilde{\gamma}_n(a);$$

$$\text{Si } \bigoplus_{n \in H(m)} \left( h_{m,n} \otimes s_n \right) = 0, \ \forall m \in \{1,2,\ldots,M\} \text{ alors SORTIR ;}$$

• *Messages des noeuds de variable*

Pour chaque noeud de variable $n \in \{1,2,...,N\}$ et chaque noeud de contrôle $m \in H(n)$ faire :

$$\alpha_{m,n}(a) = \widetilde{\gamma}_n(a) - \beta_{m,n}(a); \qquad \qquad \Big] \ \forall a \in GF(q)$$

$$\alpha_{m,n} = \min_{a \in GF(q)} \alpha_{m,n}(a);$$

$$\alpha_{m,n}(a) = \alpha_{m,n}(a) - \alpha_{m,n}; \qquad \qquad \Big] \ \forall a \in GF(q)$$

Dans les calculs ci-dessus, on utilise pour déterminer le résultat de chacune des formules de type « min-max » l'algorithme présenté ci-dessus ("*//calcul de la formule « min-max » implémentation sélective*").

Par ailleurs, tel qu'il a été précisé auparavant, dans l'étape d'initialisation, on modifie la dynamique des informations a *priori* de sorte que la partie entière des messages échangés nous fournisse un critère suffisamment fin pour distinguer entre les symboles de l'alphabet (ici le corps de Galois $GF(q)$). En pratique, le calcul de $\gamma_{\text{ave}}$ peut être fait seulement périodiquement, sachant que sa variation entre deux mots de code consécutifs est négligeable.

Les paramètres évoqués ci-dessus sont de préférence choisis tels que :

- après multiplication par $\dfrac{AI}{\gamma_{\text{ave}}}$, les valeurs des informations a *priori* $\gamma_n(a)$ soient suffisamment espacées, de sorte que les ensembles de type $\Delta_k$ contiennent peu de symboles ;

- la valeur de *COT,* qui peut être déterminée au moyen de simulations, doit être relativement faible car elle détermine le nombre d'ensembles de type $\Delta_k$ qui seront utilisés.

On peut noter à ce sujet que les valeurs des constantes *AI* et *COT* données comme exemple ci-dessus sur GF(8) ont été déterminées au moyen de simulations et peuvent être utilisées pour un canal AWGN et pour tout code LDPC sur GF(8), indépendamment des caractéristiques du code (longueur, irrégularité, rendement) ou de la modulation utilisée.

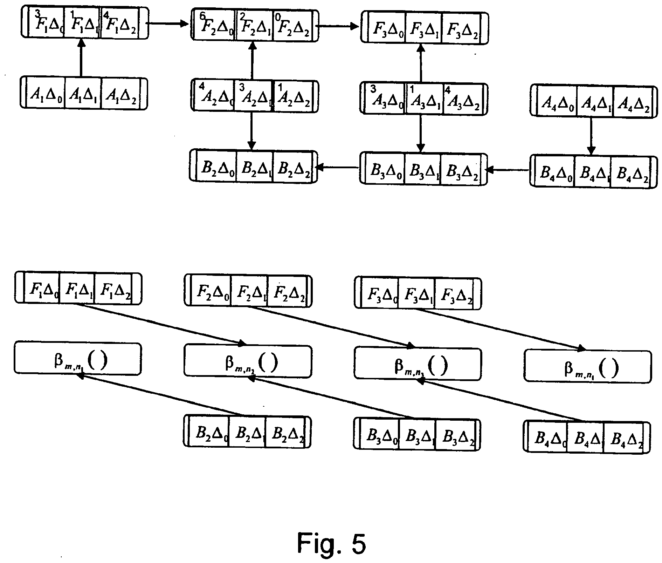

L'utilisation conjointe des ensembles $A_j\Delta_k$, $F_j\Delta_k$, $B_j\Delta_k$ et de la méthode « forward - backward » est décrite schématiquement à titre purement explicatif à la figure 5, pour une constante *COT* égale à 3 et un noeud de contrôle m de degré 4 ($H(m) = \{n_1, n_2, n_3, n_4\}$).

Dans cet exemple donné sur la base du corps de Galois soit GF(8), on considère que les ensembles $F_1\Delta_k$, $k = 0,1,2$, contiennent respectivement 3, 1 et 4 symboles et que les ensembles $A_1,\Delta_k$, $k = 0,1,2$, contiennent respectivement 4, 3 et 1 symboles. Alors, pour le calcul des valeurs $F_2(a)$, $a \in GF(8)$, il suffit d'utiliser les valeurs $F_1(a')$ et $a_{m,n2}(a'')$ correspondant aux symboles $a' \in F_1\Delta_k$ et $a'' \in A_2\Delta_k$ seulement pour $k = 0$ et $k = 1$ 1 (donc 4 symboles $a'$ et 7 symboles $a''$, soit un total de 11 symboles, ce qui est suffisant puisqu'on doit avoir au minimum $q+1=9$ symboles au total).

Une fois les valeurs $F_2(a)$, $a \in GF(8)$ calculées, les symboles $a \in GF(8)$ sont stockés dans les ensembles $F_2\Delta_k$, $k = 0,1,2$ (selon les parties entières des valeurs calculées). Supposons que les ensembles $F_2\Delta_k$, $k = 0,1,2$, contiennent respectivement 6, 2 et 0 symboles. Alors, pour le calcul des valeurs $F_3(a)$, $a \in GF(8)$, il suffit d'utiliser seulement les valeurs $F_2(a')$ et $a_{m,n3}(a'')$ correspondant aux 6 symboles $a' \in F_2\Delta_0$ et aux 3 symboles $a'' \in A_3\Delta_0$ (soit un total de 9 symboles).

On présente dans la suite le résultat de simulations comparatives des différents algorithmes envisagés ci-dessus et dans l'art antérieur, ici pour des codes LDPC sur GF(8) ou binaires.

On dénomme MMA (pour "*Min-Max Algorithm*") l'algorithme objet de la présente invention, "*implémentation standard*" son premier mode de réalisation ci-dessus et "*implémentation sélective*" son second mode de réalisation.

Tous les codes utilisés sont des codes LDPC irréguliers. Le graphe bipartite est construit en utilisant l'algorithme "*Progressive Edge Growth*", décrit dans "Regular and irregular progressive edge - growth Tanner graphs", X. Y. Hu, E. Eleftheriou, D. M. Arnold, IEEE Trans. Inform. Theory, vol. 51, no. 1, pp. 386 - 398, 2005. Dans le cas d'un code LDPC sur GF(8), les arêtes du graphe bipartite correspondent aux places des coefficients non nuls dans la matrice de parité. Ces coefficients ont été choisis de manière aléatoire. On n'indiquera pas dans la suite l'irrégularité des codes utilisés, mais nous indiquerons le degré moyen des noeuds de variable, qui sera noté $d_n^{\mathrm{ave}}$.

Les *irrégularités* des codes LDPC binaires ont été optimisées par "*évolution de densité*" comme décrit dans "Design of capacity approaching irregular low density parity check codes", T. J. Richardson, M. A. Shokrollahi, R. L. Urbanke, IEEE Trans. Inform. Theory, vol. 47, no. 2, pp. 619 - 637, 2001. Néanmoins, l'irrégularité correspondant à un bon code binaire ne convient pas pour obtenir un bon code q -aire (et réciproquement). Généralement, plus le cardinal du corps de Galois augmente, plus les codes utilisés doivent être "creux" (moins d'arêtes dans le graphe bipartite), d'où la différence entre les degrés moyens des noeuds de variable pour les codes binaires et pour les codes sur GF(8) utilisés ci-dessous.

Les simulations ont été réalisées pour un canal AWGN, en utilisant une modulation QPSK. Par ailleurs les comparaisons de performances sont faites pour un taux d'erreur binaire (BER) de $10^{-5}$. Le nombre maximum d'itérations est fixé à 200.

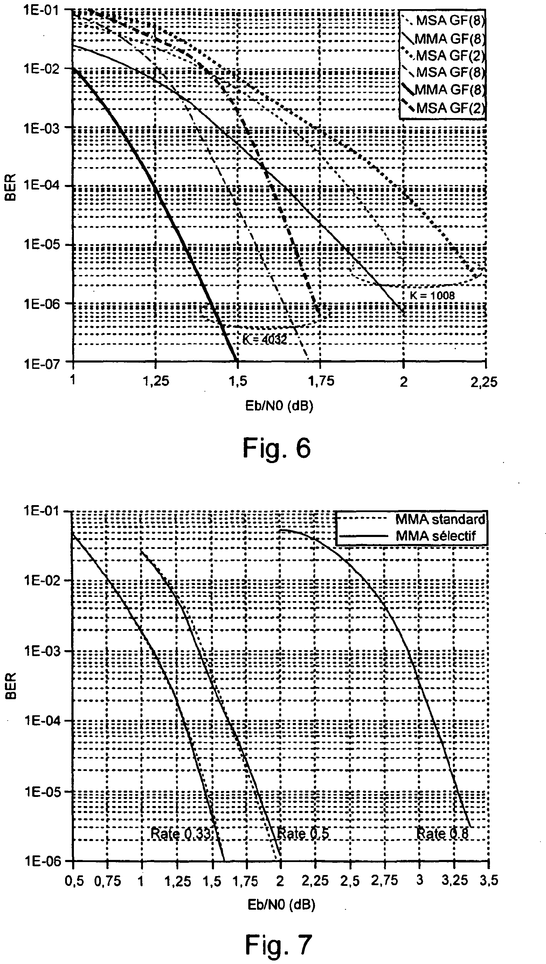

**La figure 6** représente des performances des décodeurs MMA et MSA avec un code LDPC sur GF(8), et du décodeur MSA avec un code LDPC binaire pour des codes ayant les caractéristiques suivantes :

- 1008 bits (soit 336 symboles) d'information, 2016 bits (soit 672 symboles) codés (soit un rendement de 1/2) d'une part ;
- 4032 bits (soit 1344 symboles) d'information, 8064 bits (soit 2688 symboles) codés (soit un rendement de 1/2) d'autre part ;

- pour les codes binaires : $d_n^{\mathrm{ave}} = 3.27$ ;

- pour les codes sur GF(8) : $d_n^{\mathrm{ave}} = 2.5$.

On remarque que :

- pour les codes LDPC sur GF(8), le décodeur MMA devance le décodeur MSA de 0.15 à 0.22 dB ;
- le code sur GF(8) (décodage MMA) devance le code binaire de 0.33 dB.

On peut également noter que, suite aux simulations réalisées (non représentées), on a constaté que pour les codes LDPC sur GF(8), le décodeur MMA est à seulement 0.04 dB du décodeur SPA.

On compare par ailleurs en référence à la **figure 7** les performances du décodeur MMA, obtenues en utilisant les implémentations "*standard' et* "*sélective*". On utilise des codes LDPC sur GF(8) de longueur binaire égale à 2016 bits et de rendements 1/3, 1/2 et 4/5, dont les degrés moyens des noeuds de variables sont respectivement 2.4, 2.5 et 2.8. Par ailleurs, les constantes *AI* et *COT* utilisées pour l'implémentation sélective ont été fixées à :

$$AI = 4.647, \ COT = 10.$$

On remarque au vu de la figure 7 que les performances obtenues sont (quasiment) identiques, autrement dit qu'il n'y a pas de perte substantielle de performance de l'implémentation sélective par rapport à l'implémentation standard.

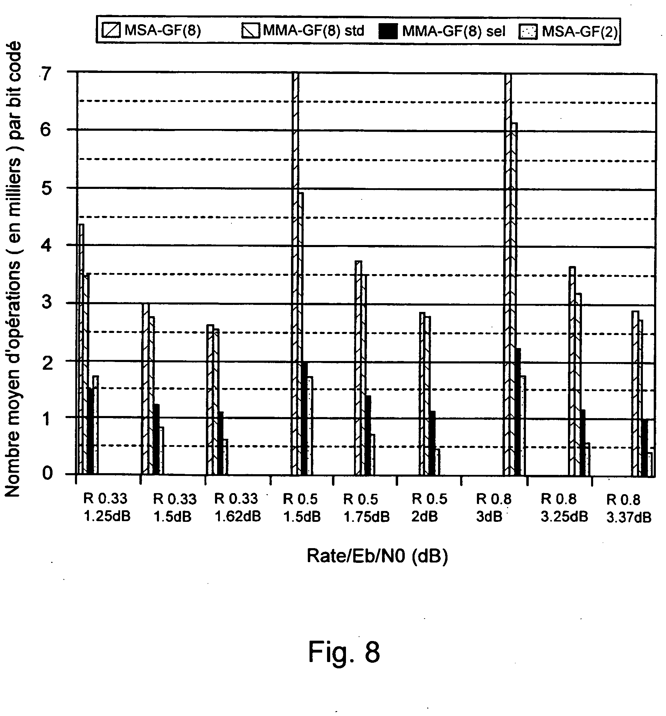

**La figure 8** permet la comparaison de la complexité des décodages MSA et MMA (implémentations standard et sélective) sur GF(8), et du décodage MSA sur GF(2) (code binaire).

Le nombre d'opérations représente le nombre moyen d'opérations en milliers par bit codé (toutes itérations cumulées), effectuées par les deux décodeurs. Ce nombre est dépendant du rapport signal-bruit (SNR) car le nombre moyen d'itérations effectuées par les deux décodeurs décroît lorsque le rapport signal-bruit $E_b/N_0$ augmente.

Pour chaque rendement (1/3, 1/2 et 4/5) nous avons enregistré le nombre moyen d'opérations par bit codé pour les valeurs de $E_b/N_0$, correspondant à la région de chute du BER.

Sur GF(8), le décodeur MMA - standard est moins complexe que le décodeur MSA. Ceci est dû au fait que le décodeur MMA converge plus rapidement que le MSA; autrement dit, le nombre d'itérations effectuées par le MMA est inférieur au nombre d'itérations effectuées par le MSA (les deux décodeurs effectuant quasiment le même nombre d'opérations par itération).

Sur GF(8), le décodeur MMA - sélectif est 2 à 3 fois moins complexe que le décodeur MMA - standard. Le nombre d'itérations effectuées par les deux décodeurs est le même mais, pour chaque itération, le MMA - sélectif effectue moins d'opérations que le MMA - standard.

Finalement, on observe que le décodeur MMA - sélectif sur GF(8) est seulement 1 à 2 fois plus complexe que le décodeur MSA binaire.

Les modes de réalisation présentés ci-dessus ne sont que des exemples possibles de mise en oeuvre de l'invention, qui ne s'y limite pas.

**ANNEXE**

On considère deux fonctions $f'$ et $f''$ définies sur *GF(q)* et à valeurs réelles, et f la fonction définie par la formule « min-max » :

$$f(a) = \min_{\substack{a',a'' \in GF(q) \\ a' \oplus a'' = a}} \left( \max\left( f'(a'), f''(a'') \right) \right)$$

Soient $\Delta'$ et $\Delta''$ des sous-ensembles de *GF(q)* tels que l'ensemble des valeurs

$$\left\{ f'(a') \,\middle|\, a' \in \Delta' \right\} \cup \left\{ f''(a'') \,\middle|\, a'' \in \Delta'' \right\}$$

contienne les *q*+1 valeurs les plus faibles parmi toutes les valeurs de $f'$ et $f''$, *i.e.* parmi

$$\left\{ f'(a') \,\middle|\, a' \in GF(q) \right\} \cup \left\{ f''(a'') \,\middle|\, a'' \in GF(q) \right\}.$$

On va montrer que l'on peut alors calculer *f(a)* par la formule

$$f(a) = \min_{\substack{a' \in \Delta', a'' \in \Delta'' \\ a' \oplus a'' = a}} \left( \max\left( f'(a'), f''(a'') \right) \right)$$

qui implique un nombre réduit de symboles *a'* et *a''*.

Dans une première étape, on va montrer que tout symbole $a \in GF(q)$ peut s'écrire comme la somme de deux symboles :

$$a = \delta' + \delta'' \text{ avec } \delta' \in \Delta' \text{ et } \delta'' \in \Delta''.$$

Pour cela on définit deux fonctions $I, T_a : GF(q) \to GF(q)$ par $I(x) = x$ (fonction identité) et $T_a(x) = a \oplus x$ (translation par *a*). En remarquant que les deux fonctions sont bijectives, on obtient

$$\mathrm{card}\left( I(\Delta') \right) + \mathrm{card}\left( T_a(\Delta'') \right) = \mathrm{card}\left( \Delta' \right) + \mathrm{card}\left( \Delta'' \right) \geq q + 1 > \mathrm{card}\left( GF(q) \right)$$

Il s'ensuit qu'il existe $\delta' \in \Delta'$ et $\delta'' \in \Delta''$ tels que :

$$I(\delta') = T_a(\delta''),$$

ce qui équivaut à $\delta' = a \oplus \delta''$, d'où $a = \delta' \oplus \delta''$.

Dans une seconde étape de la démonstration, on note $s',s'' \in GF(q)$ les deux symboles tels que $s' \oplus s'' = a$, réalisant le minimum dans la définition de $f(a)$, autrement dit, tels que

$$\max\left(f'(s'), f''(s'')\right) = \min_{\substack{a',a'' \in GF(q) \\ a' \oplus a'' = a}} \left(\max\left(f'(a'), f''(a'')\right)\right) = f(a)$$

Soient $\delta' \in \Delta'$ et $\delta'' \in \Delta''$ tels que $a = \delta' + \delta''$ (d'après la première étape). Rappelons que les symboles de $\Delta'$ et $\Delta''$ correspondent aux $q + 1$ valeurs les plus faibles parmi l'ensemble des valeurs des fonctions $f'$ et $f''$.

Alors (en raisonnant par l'absurde) si l'on avait $s' \notin \Delta'$ ou $s'' \notin \Delta''$, l'une au moins des valeurs $f'(s')$, $f''(s'')$ serait en dehors des $q+1$ valeurs les plus faibles et on obtiendrait donc

$$\max\left(f'(\delta'), f''(\delta'')\right) < \max\left(f'(s'), f''(s'')\right),$$

ce qui contredit le caractère minimal du couple $s',s''$.

On a donc nécessairement $s' \in \Delta'$ et $s'' \in \Delta''$ et par conséquent

$$f(a) = \max\left(f'(s'), f''(s'')\right) = \min_{\substack{a'\Delta', a'' \in \Delta'' \\ a' \oplus a'' = a}} \left(\max\left(f'(a'), f''(a'')\right)\right)$$

## Revendications

1. Procédé de décodage itératif d'un mot reçu, représenté par des valeurs d'un signal, selon un code à matrice de contrôle de parité, du type à passage de messages entre des noeuds de variable et des noeuds de contrôle d'un graphe bipartite associé à ladite matrice, **caractérisé en ce qu'**il comprend une étape d'initialisation d'au moins un message d'un noeud de variable, en fonction desdites valeurs, par une information représentative du rapport entre la probabilité d'avoir le symbole le plus probable à la position correspondant au noeud de variable et la probabilité d'avoir le symbole courant à ladite position.

2. Procédé de décodage selon la revendication 1, comprenant une étape de détermination d'au moins un message, relatif à un symbole déterminé, d'un noeud de contrôle vers un noeud de variable déterminé, comme la valeur minimale prise, parmi les séquences de symboles vérifiant l'équation au noeud de contrôle en utilisant ledit symbole déterminé au noeud de variable déterminé, par la valeur maximale des messages reçus au noeud de contrôle depuis des noeuds de variable autres que le noeud de variable déterminé et relatifs chacun au symbole associé à cet autre noeud de variable dans la séquence vérifiant l'équation.

3. Procédé de décodage selon la revendication 1 ou 2, comprenant une étape de détermination des messages d'un noeud de variable vers un noeud de contrôle relatifs à l'ensemble des symboles de telle sorte que la valeur minimale desdits messages soit nulle.

4. Procédé de décodage selon l'une des revendications 1 à 3, dans lequel l'étape d'initialisation du message d'un noeud de variable comprend les étapes suivantes :

   - pour chaque symbole de l'alphabet, détermination de la somme des rapports de vraisemblance logarithmique binaires relatifs aux bits non-nuls du symbole et à la position correspondant au noeud de variable et ;
   - détermination du minimum des sommes déterminées ;
   - soustraction à chaque somme déterminée du minimum déterminé.

5. Procédé de décodage selon l'une des revendications 1 à 4, comprenant une étape de détermination d'une information *a posteriori* relative à un noeud de variable et à un symbole, comme la somme du message initial relatif au symbole audit noeud de variable et de l'ensemble des messages reçus au noeud de variable et relatifs au symbole.

**6.** Procédé de décodage selon la revendication 5, comprenant les étapes suivantes :

- pour chaque noeud de variable, détermination du symbole pour lequel l'information *a posteriori* est minimale ;
- si la séquence des symboles ainsi déterminés pour l'ensemble des noeuds de variable est un mot de code, utilisation dudit mot de code comme mot estimé.

**7.** Procédé de décodage selon l'une des revendications 3 à 6, les revendications 4 et 5 étant prises dans la dépendance de la revendication 3, dans lequel l'étape de détermination des messages d'un noeud de variable vers un noeud de contrôle donné comprend les étapes suivantes :

- pour chaque symbole, détermination de la somme du message initial relatif au symbole audit noeud de variable et de l'ensemble des messages reçus au noeud de variable en provenance d'un noeud de contrôle autre que le noeud de contrôle donné et relatifs au symbole ;
- détermination du minimum parmi les sommes déterminées ;
- pour chaque symbole, soustraction du minimum déterminé à la somme déterminée relative au symbole.

**8.** Procédé de décodage selon l'une des revendications 2 à 7, les revendications 3 à 7 étant prises dans la dépendance de la revendication 2, dans lequel l'étape de détermination d'au moins un message d'un noeud de contrôle vers un noeud de variable déterminé comprend les étapes suivantes :

- détermination, pour chaque symbole, d'une valeur intermédiaire égale à la valeur minimale prise par la valeur maximale de messages reçus au noeud de contrôle depuis une partie seulement des noeuds de variable associés au noeud de contrôle ;
- détermination de la valeur minimale prise par la valeur maximale parmi des valeurs intermédiaires et des messages reçus d'un noeud de variable associé au noeud de contrôle et n'appartenant pas à ladite partie.

**9.** Procédé de décodage selon l'une des revendications 1 à 8, comprenant une étape de détermination du minimum, parmi des couples de deux symboles appartenant à l'alphabet du code, du maximum de deux valeurs associées respectivement aux deux symboles de chaque couple, comprenant les sous-étapes suivantes :

- détermination d'ensembles regroupant chacun les symboles auxquels sont associées des valeurs comprises dans un intervalle déterminé ;
- sélection d'ensembles, parmi les ensembles déterminés, de telle sorte que la réunion des ensembles sélectionnés contienne au moins un nombre prédéterminé de symboles ;
- utilisation, comme maximum parmi deux valeurs, de la valeur associée au symbole compris dans l'ensemble correspondant à l'intervalle supérieur lorsque les valeurs sont associées à des symboles compris dans des ensembles sélectionnés correspondant à des intervalles distincts ;
- détermination par comparaison du maximum parmi deux valeurs lorsque les valeurs sont associées à des symboles compris dans des ensembles sélectionnés correspondant à un même intervalle.

**10.** Procédé de décodage selon l'une des revendications 1 à 9, dans lequel le code est un code à alphabet non-binaire.

**11.** Dispositif de décodage itératif d'un mot reçu, représenté par des valeurs d'un signal, selon un code à matrice de contrôle de parité, du type à passage de messages entre des noeuds de variable et des noeuds de contrôle d'un graphe bipartite associé à ladite matrice, **caractérisé en ce qu'**il comprend des moyens d'initialisation d'au moins un message d'un noeud de variable, en fonction desdites valeurs, par une information représentative du rapport entre la probabilité d'avoir le symbole le plus probable à la position correspondant au noeud de variable et la probabilité d'avoir le symbole courant à ladite position.

**12.** Dispositif de décodage selon la revendication 11, comprenant des moyens de détermination d'au moins un message, relatif à un symbole déterminé, d'un noeud de contrôle vers un noeud de variable déterminé, comme la valeur minimale prise, parmi les séquences de symboles vérifiant l'équation au noeud de contrôle en utilisant ledit symbole déterminé au noeud de variable déterminé, par la valeur maximale des messages reçus au noeud de contrôle depuis des noeuds de variable autres que le noeud de variable déterminé et relatifs chacun au symbole associé à cet autre noeud de variable dans la séquence vérifiant l'équation.

**13.** Dispositif de décodage selon la revendication 11 ou 12, comprenant des moyens de détermination des messages d'un noeud de variable vers un noeud de contrôle relatifs à l'ensemble des symboles de telle sorte que la valeur minimale desdits messages soit nulle.

**14.** Dispositif de décodage selon l'une des revendications 11 à 13, dans lequel les moyens d'initialisation du message d'un noeud de variable comprennent :

- des moyens pour déterminer, pour chaque symbole de l'alphabet, la somme des rapports de vraisemblance logarithmique binaires relatifs aux bits non- nuls du symbole et à la position correspondant au noeud de variable et;
- des moyens pour déterminer le minimum des sommes déterminées ;
- des moyens pour soustraire le minimum déterminé de chaque somme déterminée.

**15.** Dispositif de décodage selon l'une des revendications 11 à 14, comprenant des moyens de détermination d'une information *a posteriori* relative à un noeud de variable et à un symbole, comme la somme du message initial relatif au symbole audit noeud de variable et de l'ensemble des messages reçus au noeud de variable et relatifs au symbole.

**16.** Dispositif de décodage selon la revendication 15, comprenant :

- des moyens pour déterminer, pour chaque noeud de variable, le symbole pour lequel l'information *a posteriori* est minimale ;
- des moyens pour utiliser la séquence des symboles ainsi déterminés pour l'ensemble des noeuds de variable comme mot estimé si ladite séquence est un mot de code.

**17.** Dispositif de décodage selon l'une des revendications 13 à 16, les revendications 14 et 15 étant prises dans la dépendance de la revendication 13, dans lequel les moyens de détermination des messages d'un noeud de variable vers un noeud de contrôle donné comprennent :

- des moyens pour déterminer, pour chaque symbole, la somme du message initial relatif au symbole audit noeud de variable et de l'ensemble des messages reçus au noeud de variable en provenance d'un noeud de contrôle autre que le noeud de contrôle donné et relatifs au symbole ;
- des moyens pour déterminer le minimum parmi les sommes déterminées ;
- des moyens pour soustraire, pour chaque symbole, le minimum déterminé à la somme déterminée relative au symbole.

**18.** Dispositif de décodage selon l'une des revendications 12 à 17, les revendications 13 à 15 étant prises dans la dépendance de la revendication 12, dans lequel les moyens de détermination d'au moins un message d'un noeud de contrôle vers un noeud de variable déterminé comprennent :

- des moyens pour déterminer, pour chaque symbole, une valeur intermédiaire égale à la valeur minimale prise par la valeur maximale de messages reçus au noeud de contrôle depuis une partie seulement des noeuds de variable associés au noeud de contrôle ;
- des moyens pour déterminer la valeur minimale prise par la valeur maximale parmi des valeurs intermédiaires et des messages reçus d'un noeud de variable associé au noeud de contrôle et n'appartenant pas à ladite partie.

**19.** Dispositif de décodage selon l'une des revendications 11 à 18, dans lequel des moyens pour déterminer le minimum, parmi des couples de deux symboles appartenant à l'alphabet du code, du maximum de deux valeurs associées respectivement aux deux symboles de chaque couple, comprennent :

- des moyens de détermination d'ensembles regroupant chacun les symboles auxquels sont associées des valeurs comprises dans un intervalle déterminé ;
- des moyens de sélection d'ensembles, parmi les ensembles déterminés, de telle sorte que la réunion des ensembles sélectionnés contienne au moins un nombre prédéterminé de symboles ;
- des moyens utilisant, comme maximum parmi deux valeurs, la valeur associée au symbole compris dans l'ensemble correspondant à l'intervalle supérieur lorsque les valeurs sont associées à des symboles compris dans des ensembles sélectionnés correspondant à des intervalles distincts ;
- des moyens pour déterminer par comparaison le maximum parmi deux valeurs lorsque les valeurs sont associées à des symboles compris dans des ensembles sélectionnés correspondant à un même intervalle.

**20.** Dispositif de décodage selon l'une des revendications 11 à 19, dans lequel le code est un code à alphabet non-binaire.

**21.** Appareil de communication comprenant un dispositif selon l'une des revendications 11 à 20.

**Claims**

**1.** Method of iterative decoding of a received word, represented by values of a signal, according to a parity check matrix code, of the type using passage of messages between variable nodes and control nodes of a bipartite graph associated with said matrix, **characterised in that** it comprises a step of initialisation of at least one message from a variable node, as a function of said values, by information representing the ratio between the probability of having the most probable symbol at the position corresponding to the variable node and the probability of having the current symbol at said position.

**2.** Decoding method according to claim 1, comprising a step of determination of at least one message, relating to a particular symbol, from a control node to a particular variable node, as the minimum value taken, among the sequences of symbols satisfying the equation at the control node using said particular symbol at the particular variable node, by the maximal value of the messages received at the control node from variable nodes other than the particular variable node and each relating to the symbol associated with that other variable node in the sequence satisfying the equation.

**3.** Decoding method according to claim 1 or 2, comprising a step of determination of the messages from a variable node to a control node which relate to all the symbols so that the minimal value of said messages is null.

**4.** Decoding method according to any one of claims 1 to 3, wherein the step of initialisation of the message from a variable node comprises the following steps:

- for each symbol of the alphabet, determination of the sum of the binary logarithmic likelihood ratios relating to the non-null bits of the symbol and to the position corresponding to the variable node;
- determination of the minimum of the sums thus determined; and
- subtraction from each sum determined of the minimum thus determined.

**5.** Decoding method according to any one of claims 1 to 4, comprising a step of determination of *a posteriori* information relating to a variable node and to a symbol, like the sum of the initial message relating to the symbol at said variable node and all messages received at the variable node and relating to the symbol.

**6.** Decoding method according to claim 5, comprising the following steps:

- for each variable node, determination of the symbol for which the *a posteriori* information is minimal;
- if the sequence of the symbols determined in this way for all variable nodes is a code word, use of said code word as estimated word.

**7.** Decoding method according to any one of claims 3 to 6, claims 4 and 5 being dependent on claim 3, wherein the step of determining the messages from a variable node to a given control node comprises the following steps:

- for each symbol, determination of the sum of the initial message relating to the symbol at said variable node and all the messages received at the variable node coming from a control node other than the given control node and relating to the symbol;
- determination of the minimum of the sums thus determined;
- for each symbol, subtraction of the minimum thus determined from the sum thus determined relating to the symbol.

**8.** Decoding method according to any one of claims 2 to 7, claims 3 to 7 being dependent on claim 2, wherein the step of determination of at least one message from a control node to a particular determined variable node comprises the following steps:

- determination, for each symbol, of an intermediate value equal to the minimal value taken by the maximal value of messages received at the control node from a portion only of the variable nodes associated with the control node;
- determination of the minimal value taken by the maximal value from intermediate values and messages received from a variable node associated with the control node and not belonging to said portion.

9.  Decoding method according to any one of claims 1 to 8, comprising a step of determination of the minimum, among the pairs of symbols belonging to the alphabet of the code, of the maximum of two values respectively associated with the two symbols of each pair, comprising the following substeps:

    - determination of sets each combining the symbols with which are associated values included in a particular range;
    - selection of sets, among the sets determined, such that the reunion of the sets selected contains at least a predetermined number of symbols;
    - use, as maximum of two values, of the value associated with the symbol included in the set corresponding to the greater range when the values are associated with symbols included in selected sets corresponding to separate ranges;
    - determination by comparison of the maximum of two values if the values are associated with symbols included in selected sets corresponding to the same range.

10. Decoding method according to any one of claims 1 to 9, wherein the code is a non-binary alphabet code.

11. Device for iterative decoding of a received word, represented by values of a signal, according to a parity check matrix code, of the type using passage of messages between variable nodes and control nodes of a bipartite graph associated with said matrix, **characterised in that** it comprises means for initialisation of at least one message from a variable node, as a function of said values, by information representing the ratio between the probability of having the most probable symbol at the position corresponding to the variable node and the probability of having the current symbol at said position.

12. Decoding method according to claim 11, comprising means for determination of at least one message, relating to a particular symbol, from a control node to a particular variable node, as the minimum value taken, among the sequences of symbols satisfying the equation at the control node using said particular symbol at the particular variable node, by the maximal value of the messages received at the control node from variable nodes other than the particular variable node and each relating to the symbol associated with that other variable node in the sequence satisfying the equation.

13. Decoding method according to claim 11 or 12, comprising means for determination of the messages from a variable node to a control node which relate to the set of symbols so that the minimal value of said messages is null.

14. Decoding device according to any one of claims 11 to 13, wherein the means for initialisation of the message from a variable node comprise:

    - for each symbol of the alphabet, means for determination of the sum of the binary logarithmic likelihood ratios relating to the non-null bits of the symbol and to the position corresponding to the variable node;
    - means for determination of the minimum of the sums determined; and
    - means for subtraction from each sum thus determined of the minimum thus determined.

15. Decoding device according to any one of claims 11 to 14, comprising means for determination of a posteriori information relating to a variable node and to a symbol, like the sum of the initial message relating to the symbol at said variable node and all messages received at the variable node and relating to the symbol.

16. Decoding device according to claim 15, comprising:

    - for each variable node, means for determination of the symbol for which the a posteriori information is minimal;
    - if said sequence is a code word, means for using said code word as an estimated word.

17. Decoding device according to any one of claims 13 to 16, claims 14 and 15 being dependent on claim 13, wherein the means for determination of the messages from a variable node to a given control node comprise:

    - for each symbol, means for determination of the sum of the initial message relating to the symbol at said variable node and all messages received at the variable node coming from a control node other than the given control node and relating to the symbol;

- means for determination of the minimum of the sums thus determined;
- for each symbol, means for subtraction of the minimum thus determined from the sum thus determined relating to the symbol.

18. Decoding device according to any one of claims 12 to 17, claims 13 to 15 being dependent on claim 12, wherein the means for determination of at least one message from a control node to a particular variable node comprise:

- means for determination, for each symbol, of an intermediate value equal to the minimal value taken by the maximal value of messages received at the control node from a portion only of the variable nodes associated with the control node;
- means for determination of the minimal value taken by the maximal value of the intermediate values and messages received from a variable node associated with the control node and not belonging to said portion.

19. Decoding device according to any one of claims 11 to 18, wherein the means for determination of the minimum, from the pairs of symbols belonging to the alphabet of the code, of the maximum of two values respectively associated with the two symbols of each pair, comprise:

- means for determination of sets each combining the symbols with which are associated values included in a particular range;
- means for selection of sets, among the sets thus determined, such that the reunion of the sets selected contains at least a predetermined number of symbols;
- means using, as maximum of two values, the value associated with the symbol included in the set corresponding to the greater range when the values are associated with symbols included in selected sets corresponding to separate ranges;
- means for determination by comparison of the maximum of two values if the values are associated with symbols included in selected sets corresponding to the same range.

20. Decoding device according to any one of claims 11 to 19, wherein the code is a non-binary alphabet code.

21. Communication apparatus comprising a device according to any one of claims 11 to 20.

**Patentansprüche**

1. Verfahren zur iterativen Decodierung eines durch Werte eines Signals dargestellten empfangenen Wortes entsprechend einem Code mit Paritätskontrollmatrix, vom Typ mit Nachrichtenaustausch zwischen Variablenknoten und Kontrollknoten eines der Matrix zugeordneten zweiteiligen Graphen, **dadurch gekennzeichnet, dass** es einen Schritt zur Initialisierung wenigstens einer Nachricht eines Variablenknotens in Abhängigkeit der Werte durch eine Information umfasst, welche repräsentativ ist für das Verhältnis zwischen der Wahrscheinlichkeit, das wahrscheinlichste Symbol an der dem Variablenknoten entsprechenden Position zu haben, und der Wahrscheinlichkeit, das übliche Symbol an der genannten Position zu haben.

2. Decodierverfahren nach Anspruch 1, umfassend einen Schritt zur Bestimmung wenigstens einer Nachricht, bezüglich eines bestimmten Symbols und von einem Kontrollknoten zu einem bestimmten Variablenknoten, als den Minimalwert, der unter den Symbolfolgen, welche die Gleichung an dem Kontrollknoten unter Verwendung des bestimmten Symbols an dem bestimmten Variablenknoten erfüllen, genommen wird durch den Maximalwert der an dem Kontrollknoten von anderen Variablenknoten als dem bestimmten Variablenknoten empfangenen Nachrichten und bezüglich jeweils des diesem anderen Variablenknoten zugeordneten Symbols in der die Gleichung erfüllenden Folge.

3. Decodierverfahren nach Anspruch 1 oder 2, umfassend einen Schritt zur Bestimmung der Nachrichten von einem Variablenknoten zu einem Kontrollknoten bezüglich aller Symbole, derart, dass der Minimalwert der Nachrichten gleich Null ist.

4. Decodierverfahren nach einem der Ansprüche 1 bis 3, wobei der Schritt zur Initialisierung der Nachricht eines Variablenknotens die folgenden Schritte umfasst:

- für jedes Symbol des Alphabets Bestimmen der Summe der binären Log-Likelihood-Verhältnisse bezüglich der Nicht-Null-Bits des Symbols und der dem Variablenknoten entsprechenden Position, und
- Bestimmen des Minimums der bestimmten Summen,
- Subtrahieren des bestimmten Minimums von jeder bestimmten Summe.

**5.** Decodierverfahren nach einem der Ansprüche 1 bis 4, umfassend einen Schritt zur Bestimmung einer A-posteriori-Information bezüglich eines Variablenknotens und eines Symbols als die Summe aus der Ausgangsnachricht bezüglich des Symbols an dem Variablenknoten und allen an dem Variablenknoten empfangenen Nachrichten bezüglich des Symbols.

**6.** Decodierverfahren nach Anspruch 5, umfassend die folgenden Schritte:

- für jeden Variablenknoten Bestimmen des Symbols, bei dem die A-posteriori-Information minimal ist,
- wenn die Folge der auf diese Weise für alle Variablenknoten bestimmten Symbole ein Codewort ist, Verwenden des Codewortes als Schätzwort.

**7.** Decodierverfahren nach einem der Ansprüche 3 bis 6, wobei die Ansprüche 4 und 5 in Abhängigkeit von Anspruch 3 genommen werden, wobei der Schritt zur Bestimmung der Nachrichten von einem Variablenknoten zu einem gegebenen Kontrollknoten die folgenden Schritte umfasst:

- für jedes Symbol Bestimmen der Summe aus der Ausgangsnachricht bezüglich des Symbols an dem Variablenknoten und allen Nachrichten bezüglich des Symbols, die an dem Variablenknoten von einem anderen Kontrollknoten als dem gegebenen Kontrollknoten kommend empfangen werden,
- Bestimmen des Minimums unter den bestimmten Summen,
- für jedes Symbol Subtrahieren des bestimmten Minimums von der bestimmten Summe bezüglich des Symbols.

**8.** Decodierverfahren nach einem der Ansprüche 2 bis 7, wobei die Ansprüche 3 bis 7 in Abhängigkeit von Anspruch 2 genommen werden, wobei der Schritt zur Bestimmung wenigstens einer Nachricht von einem Kontrollknoten zu einem bestimmten Variablenknoten die folgenden Schritte umfasst:

- für jedes Symbol Bestimmen eines Zwischenwertes gleich dem angenommenen Minimalwert mittels des Maximalwertes von Nachrichten, die an dem Kontrollknoten von nur einem Teil der dem Kontrollknoten zugeordneten Variablenknoten empfangen werden,
- Bestimmen des angenommenen Minimalwertes mittels des Maximalwertes aus Zwischenwerten und Nachrichten, die von einem dem Kontrollknoten zugeordneten und nicht zu dem Teil gehörenden Variablenknoten empfangen werden.

**9.** Decodierverfahren nach einem der Ansprüche 1 bis 8, umfassend einen Schritt zur Bestimmung des Minimums aus Paaren von zwei zu dem Alphabet des Codes gehörenden Symbolen, des Maximums von zwei Werten, die jeweils den beiden Symbolen eines jeden Paares zugeordnet sind, umfassend die folgenden Unterschritte:

- Bestimmen von Einheiten, die jeweils die Symbole zusammenfassen, denen in einem bestimmten Bereich liegende Werte zugeordnet sind,
- Auswählen von Einheiten aus den bestimmten Einheiten derart, dass die Verknüpfung der ausgewählten Einheiten wenigstens eine vorbestimmte Anzahl von Symbolen enthält,
- Verwenden des Wertes als Maximum aus zwei Werten, der dem in der dem oberen Bereich entsprechenden Einheit enthaltenen Symbol zugeordnet ist, wenn die Werte Symbolen zugeordnet sind, die in ausgewählten, unterschiedlichen Bereichen entsprechenden Einheiten enthalten sind,
- Bestimmen mittels Vergleich des Maximums aus zwei Werten, wenn die Werte Symbolen zugeordnet sind, die in ausgewählten, einem gleichen Bereich entsprechenden Einheiten enthalten sind.

**10.** Decodierverfahren nach einem der Ansprüche 1 bis 9, wobei der Code ein Code mit nicht binärem Alphabet ist.

**11.** Vorrichtung zur iterativen Decodierung eines durch Werte eines Signals dargestellten empfangenen Wortes entsprechend einem Code mit Paritätskontrollmatrix vom Typ mit Nachrichtenaustausch zwischen Variablenknoten und Kontrollknoten eines der Matrix zugeordneten zweiteiligen Graphen, **dadurch gekennzeichnet, dass** sie Mittel zur Initialisierung wenigstens einer Nachricht eines Variablenknotens in Abhängigkeit der Werte durch eine Information umfasst, welche repräsentativ ist für das Verhältnis zwischen der Wahrscheinlichkeit, das wahrscheinlichste Symbol an der dem Variablenknoten entsprechenden Position zu haben, und der Wahrscheinlichkeit, das übliche Symbol an der genannten Position zu haben.

12. Decodiervorrichtung nach Anspruch 11, umfassend Mittel zur Bestimmung wenigstens einer Nachricht, bezüglich eines bestimmten Symbols und von einem Kontrollknoten zu einem bestimmten Variablenknoten, als den Minimalwert, der unter den Symbolfolgen, welche die Gleichung an dem Kontrollknoten unter Verwendung des bestimmten Symbols an dem bestimmten Variablenknoten erfüllen, genommen wird durch den Maximalwert der an dem Kontrollknoten von anderen Variablenknoten als dem bestimmten Variablenknoten empfangenen Nachrichten und bezüglich jeweils des diesem anderen Variablenknoten zugeordneten Symbols in der die Gleichung erfüllenden Folge.

13. Decodiervorrichtung nach Anspruch 11 oder 12, umfassend Mittel zur Bestimmung der Nachrichten von einem Variablenknoten zu einem Kontrollknoten bezüglich aller Symbole derart, dass der Minimalwert der Nachrichten gleich Null ist.

14. Decodiervorrichtung nach einem der Ansprüche 11 bis 13, wobei die Mittel zur Initialisierung der Nachricht eines Variablenknotens folgendes umfassen:

- Mittel zur Bestimmung, für jedes Symbol des Alphabets, der Summe der binären Log-Likelihood-Verhältnisse bezüglich der Nicht-Null-Bits des Symbols und der dem Variablenknoten entsprechenden Position, und
- Mittel zur Bestimmung des Minimums der bestimmten Summen,
- Mittel zum Subtrahieren des bestimmten Minimums von jeder bestimmten Summe.

15. Decodiervorrichtung nach einem der Ansprüche 11 bis 14, umfassend Mittel zur Bestimmung einer A-posteriori-Information bezüglich eines Variablenknotens und eines Symbols als die Summe aus der Ausgangsnachricht bezüglich des Symbols an dem Variablenknoten und allen an dem Variablenknoten empfangenen Nachrichten bezüglich des Symbols.

16. Decodiervorrichtung nach Anspruch 15, umfassend:

- Mittel zur Bestimmung, für jeden Variablenknoten, des Symbols, bei dem die A-posteriori-Information minimal ist,
- Mittel zur Verwendung der Folge der auf diese Weise für alle Variablenknoten bestimmten Symbole als Schätzwort, wenn die Folge ein Codewort ist.

17. Decodiervorrichtung nach einem der Ansprüche 13 bis 16, wobei die Ansprüche 14 und 15 in Abhängigkeit von Anspruch 13 genommen werden, wobei die Mittel zur Bestimmung der Nachrichten von einem Variablenknoten zu einem gegebenen Kontrollknoten folgendes umfassen:

- Mittel zur Bestimmung, für jedes Symbol, der Summe aus der Ausgangsnachricht bezüglich des Symbols an dem Variablenknoten und allen Nachrichten bezüglich des Symbols, die an dem Variablenknoten von einem anderen Kontrollknoten als dem gegebenen Kontrollknoten kommend empfangen werden,
- Mittel zur Bestimmung des Minimums unter den bestimmten Summen,
- Mittel zum Subtrahieren, für jedes Symbol, des bestimmten Minimums von der bestimmten Summe bezüglich des Symbols.

18. Decodiervorrichtung nach einem der Ansprüche 12 bis 17, wobei die Ansprüche 13 bis 15 in Abhängigkeit von Anspruch 12 genommen werden, wobei die Mittel zur Bestimmung wenigstens einer Nachricht von einem Kontrollknoten zu einem bestimmten Variablenknoten folgendes umfassen:

- Mittel zur Bestimmung, für jedes Symbol, eines Zwischenwertes gleich dem angenommenen Minimalwert mittels des Maximalwertes von Nachrichten, die an dem Kontrollknoten von nur einem Teil der dem Kontrollknoten zugeordneten Variablenknoten empfangen werden,
- Mittel zur Bestimmung des angenommenen Minimalwertes mittels des Maximalwertes aus Zwischenwerten und Nachrichten, die von einem dem Kontrollknoten zugeordneten und nicht zu dem Teil gehörenden Variablenknoten empfangen werden.

19. Decodiervorrichtung nach einem der Ansprüche 11 bis 18, wobei Mittel zur Bestimmung des Minimums, aus Paaren von zwei zu dem Alphabet des Codes gehörenden Symbolen, des Maximums von zwei Werten, die jeweils den beiden Symbolen eines jeden Paares zugeordnet sind, folgendes umfassen:

- Mittel zur Bestimmung von Einheiten, die jeweils die Symbole zusammenfassen, denen in einem bestimmten Bereich liegende Werte zugeordnet sind,
- Mittel zum Auswählen von Einheiten aus den bestimmten Einheiten derart, dass die Verknüpfung der ausgewählten Einheiten wenigstens eine vorbestimmte Anzahl von Symbolen enthält,
- Mittel, die als Maximum aus zwei Werten den Wert verwenden, der dem in der dem oberen Bereich entsprechenden Einheit enthaltenen Symbol zugeordnet ist, wenn die Werte Symbolen zugeordnet sind, die in ausgewählten, unterschiedlichen Bereichen entsprechenden Einheiten enthalten sind,
- Mittel zur Bestimmung mittels Vergleich des Maximums aus zwei Werten, wenn die Werte Symbolen zugeordnet sind, die in ausgewählten, einem gleichen Bereich entsprechenden Einheiten enthalten sind.

20. Decodiervorrichtung nach einem der Ansprüche 11 bis 19, wobei der Code ein Code mit nicht binärem Alphabet ist.

21. Kommunikationsgerät, das eine Vorrichtung nach einem der Ansprüche 11 bis 20 umfasst.

$$H = \begin{pmatrix} 1 & 3 & 4 & 0 & 0 & 0 \\ 0 & 2 & 0 & 7 & 1 & 0 \\ 5 & 0 & 0 & 1 & 0 & 4 \\ 0 & 0 & 3 & 0 & 2 & 6 \end{pmatrix}$$

## Fig. 1

## Fig. 2

Fig. 3

Fig. 4

Fig. 5

Fig. 6

Fig. 7

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R. GALLAGER.** Low density parity check codes. *IEEE Trans. Inform. Theory,* 1962, vol. IT-8, 21-28
- **R. M. TANNER.** A recursive approach to low complexity codes. *IEEE Trans. Inform. Theory,* 1981, vol. 27 (5), 533-547
- **X. Y. HU ; E. ELEFTHERIOU ; D. M. ARNOLD.** Regular and irregular progressive edge - growth Tanner graphs. *IEEE Trans. Inform. Theory,* 2005, vol. 51 (1), 386-398
- **T. J. RICHARDSON ; M. A. SHOKROLLAHI ; R. L. URBANKE.** Design of capacity approaching irregular low density parity check codes. *IEEE Trans. Inform. Theory,* 2001, vol. 47 (2), 619-637